(19) Europäisches Patentamt / European Patent Office / Office européen des brevets

(11) **EP 4 555 621 B1**

(12) **EUROPEAN PATENT SPECIFICATION**

(45) Date of publication and mention
of the grant of the patent:
**08.04.2026 Bulletin 2026/15**

(21) Application number: **23742364.5**

(22) Date of filing: **04.07.2023**

(51) International Patent Classification (IPC):
*H02P 29/024* (2016.01)    *H02P 29/028* (2016.01)
*H02P 21/00* (2016.01)    *G01R 31/34* (2020.01)
*G05B 23/02* (2006.01)

(52) Cooperative Patent Classification (CPC):
**H02P 29/024; G01R 31/343; G05B 23/024;
H02P 21/0017; H02P 29/028**

(86) International application number:
**PCT/GB2023/051753**

(87) International publication number:
**WO 2024/013471 (18.01.2024 Gazette 2024/03)**

(54) **ANTI-JAM APPARATUS AND ASSOCIATED METHODS**

VORRICHTUNG GEGEN VERKLEMMUNG UND ZUGEHÖRIGE VERFAHREN

APPAREIL ANTIBROUILLAGE ET PROCÉDÉS ASSOCIÉS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **13.07.2022 GB 202210271**

(43) Date of publication of application:
**21.05.2025 Bulletin 2025/21**

(73) Proprietor: **PROMIXX LIMITED**
**Cardiff CF10 5DT (GB)**

(72) Inventors:
• **SMITH, Dave**
**Cardiff CF10 5DT (GB)**
• **BLOFELD, Matthew**
**Cardiff CF10 5DT (GB)**
• **FAULKNER-EDWARDS, Joe**
**Cardiff CF10 5DT (GB)**

(74) Representative: **Potter Clarkson**
**Chapel Quarter**
**Mount Street**
**Nottingham NG1 6HQ (GB)**

(56) References cited:
**US-A1- 2008 309 366    US-A1- 2018 130 494
US-A1- 2018 367 073**

## Description

## Technical Field

The present disclosure relates to an anti-jam apparatus and associated methods, and in particular to an apparatus generally configured to identify a motor error if an actual response of a motor to a drive signal is outside the range of expected motor behaviour defined by a modelled response to the drive signal. The apparatus is one or more of a kitchen appliance, a blender, a portable blender, a mixer, a liquidiser, and a module for one or more of the same.

## Background

Early detection of a motor error is advantageous to avoid motor damage and/or adverse knock-on effects. The problem of motor error detection can be solved by monitoring the current passing to a motor and using this information to detect a jam/overload situation so that appropriate action can be taken. An alternative approach may be to directly monitor the rotational speed of the motor shaft with a dedicated sensor. Both methods allow calculation of the motor error.

A motor 'anti-jam' feature is a mechanism involving motor jam detection and a subsequent set of manoeuvres that take advantage of the fact that the motor can operate in forward and reverse directions to potentially remove a jam. In this respect, a 'jam' may be understood as a 'blockage', 'overload' or, more generally, a motor error that characterizes a level of loading to a motor that is considered sufficiently high to require corrective action. Such terms are intended to be used interchangeably herein, unless the context requires otherwise.

Battery powered motors are unable to generate the large quantities of torque typically generated by mains powered motors. This is in part due to the limited power source of a battery relative to mains power, and also to the fact that battery powered DC motors contain permanent magnets. Permanent magnets increase a motor's running efficiency but limit maximum torque at low speed, when compared with universal motors typically found in domestic equipment.

Without a method of dealing with a jam in a motor with reduced available torque, the system is likely to simply 'cut-out' in the presence of the jam. A user would then have to switch the equipment back on after an attempt to correct the jam.

With an effective 'anti-jam' mechanism, there is increased likelihood of continued and uninterrupted motor operation.

## Sequence of Events

The basic method of jam correction relies upon cyclic forwards and backwards movement of a motor.

While simple, several variables affect overall performance of the method, such as torque, rotational distance, rotational speed, duration, and number of allowed repetitions. The method of detecting the jam can also be optimised, since if it is otherwise implemented poorly it could impinge on normal motor behaviour.

## Jam Detection

For example, systems may simply switch the motor on and off, usually by determining a fixed threshold of motor current above which a timer is activated. When the timer 'times out' - usually after a period in the 100's of milliseconds - the motor shuts down. For systems that apply a variable drive voltage to the motor, a suitable current threshold for each drive voltage can be determined based on pre-determined criteria. Once a threshold is reached, the motor would shut down after a similar time period.

Systems as described above typically have a long timeout period to account for all envisaged motor error situations. A drawback of this approach is that an overload during normal running conditions is treated no differently to an overload during motor start-up (i.e., during the spin up process) when the motor is under extra load. As a result, the detection of a jam/overload condition is significantly delayed when occurring beyond the initial start-up phase.

Another drawback of such systems is potential jam detection failure with dynamic motor drive conditions. A dynamically varying motor drive can result in a motor current that reaches a pre-determined threshold on a rapid and repetitive basis. This causes a continual timer reset, which if rapid enough to prevent timeout, would effectively disable detection altogether.

It is therefore beneficial to account for the dynamic behaviour of a motor in identifying a motor error, particularly (although not exclusively) the dynamic behaviour of a motor having reduced available torque. Such a motor may be integrated in a kitchen appliance, a blender, a portable blender, a mixer, a liquidiser, etc., more generally a system designed to manipulate a heterogeneous physical system into a more homogeneous physical state, where abrupt changes in fluid dynamics can occur. Other applications reliant on motor error detection may also benefit.

The listing or discussion of a prior-published document or any background in this specification should not necessarily be taken as an acknowledgement that the document or background is part of the state of the art or is common general knowledge. One or more aspects/examples of the present disclosure may or may not address one or more of the background issues.

US 2018/367073 A1 discloses a motor control system that includes an estimator responsive to measured motor winding voltage and measured motor winding current to generate an estimated position signal indicative of an estimate of a position of the motor and/or an estimated speed signal indicative of an estimate of a speed of the motor. A diagnostic checker circuit compares the estimated position signal and/or the estimated speed signal to a respective one of an actual position of the motor or an actual speed of the motor.

US 2018/130494 A1 discloses techniques for monitoring health of a head in a magnetic data storage drive. A health controller may be configured to receive multi-variate sensor signals indicative of a respective reference value at least one head parameter, wherein the respective reference value is based in part on at least one initial measurement of parameters of the head obtained at a first time, determine a respective predicted current value based at least in part on a respective fixed-drift model and the multi-variate sensor signals, determine a respective actual current value that is based at least in part on at least one current measurement of the head obtained at a second time later than the first time, determine a health status for the head, and store the health status in memory.

US 2008/309366 A1 discloses a system and method for detecting incipient mechanical motor faults by way of current noise cancellation. The system includes a controller configured to detect indicia of incipient mechanical motor faults. The controller further includes a processor programmed to receive a baseline set of current data from an operating motor and define a noise component in the baseline set of current data. The processor is also programmed to repeatedly receive real-time operating current data from the operating motor and remove the noise component from the operating current data in real-time to isolate any fault components present in the operating current data. The processor is then programmed to generate a fault index for the operating current data based on any isolated fault components.

## Summary

The present invention comprises an apparatus, a method performed by the apparatus, and a computer program as defined in the claims. Embodiments that do not fall within the scope of the claims are to be interpreted as examples useful for understanding the invention. According to a first aspect, there is provided an apparatus comprises at least one processor; and at least one memory including computer program code, the at least one memory and the computer program code configured to, with the at least one processor, cause the apparatus to: model a response of a motor to a drive signal using one or more filters, the one or more filters configured to define a range of expected motor behaviour associated with the drive signal; compare the modelled response with an actual response of the motor to the drive signal; and identify a motor error if the actual response of the motor is outside the range of expected motor behaviour defined by the modelled response.

The one or more filters may comprise at least one discrete-time recursive filter configured to receive a sequence of filter inputs indicative of drive signals forming part of a drive operation, and generate a plurality of respective filter outputs defining the associated modelled response of the motor, and wherein the apparatus is configured to iteratively revise the modelled response with each filter input of the sequence, using the filter output of the preceding iteration as feedback.

The sequence may be received over intervals of time. The one or more filters may comprise at least one non-recursive filter. The one or more filters may be low pass filters. The one or more filters may have unity steady state gain. The expected motor behaviour may reflect the expected behaviour of the motor at maximum allowable loading. The modelled response may be the worst-case rotational velocity of the rotor, equivalently the worst-case calculated back-EMF from the motor.

The at least one discrete-time recursive filter may comprise a plurality of linear filters each having a respective time constant for use in revising the modelled response, the respective time constants defining the time taken by the motor to reach a predefined percentage of terminal speed under different load conditions for expected motor behaviour.

The at least one discrete-time recursive filter may comprise a non-linear filter having longer and shorter time constants for use in revising the modelled response, the longer and shorter time constants defining the time taken by the motor to reach a predefined percentage of terminal speed under a range of load conditions for expected motor behaviour, and wherein the apparatus is configured to: compare each filter input of the sequence with the filter output of the preceding iteration; and when the filter input and the filter output are of the same sign, switch from the longer time constant to the shorter time constant when the magnitude of the filter input is lower than the magnitude of the filter output of the preceding iteration, otherwise use the longer time constant, and when the filter input and filter output are of the opposite sign, use the shorter time constant only.

The at least one discrete-time recursive filter may comprise a non-linear filter having rise and fall time constants for use in revising the modelled response, the rise and fall time constants defining the time taken by the motor to accelerate and decelerate to respective predefined percentages of terminal speed under a predefined load condition for expected motor behaviour, and wherein the apparatus is configured to: compare each filter input of the sequence with the filter output of the preceding iteration; and when the filter input and filter output are of the same sign, switch from the rise time constant to the fall time constant when the magnitude of the filter input is lower than the magnitude of the filter output of the preceding iteration, otherwise use the rise time constant; and when the filter input and the filter output are of the opposite sign, use the fall time constant only.

The rise and fall time constants may be the same or different.

The rise time constant and the fall time constant may each lie in the range from about 5ms to about 80ms.

The predefined percentage of terminal speed for a load condition may be $100 \times (1 - e^{-1})$. All rise and fall time constants may be measured using the factor $(1 - e^{-1})$.

The at least one discrete-time recursive filter may comprise a plurality of non-linear filters, each non-linear filter having associated rise and fall time constants for use in revising the modelled response, the associated rise and fall time constants defining the time taken by the motor to accelerate and decelerate to respective predefined percentages of terminal speed under a predefined load condition for expected motor behaviour, and wherein the apparatus is configured to: scale each filter output by a scaling factor; determine, from the scaled filter outputs of the plurality of non-linear filters at each iteration of the sequence, the scaled maximum filter output value and the scaled minimum filter output value; and if the drive signal is positive: compare the actual response of the motor to the scaled minimum filter output value, and identify a motor error if the actual response of the motor is less than the scaled minimum filter output value; or if the drive signal is negative: compare the actual response of the motor to the scaled maximum filter output value, and identify a motor error if the actual response of the motor is greater than the scaled maximum filter output value.

Determining the maximum and minimum scaled filter output values may comprise: determining the filter output having the most positive or least negative output value after scaling, whichever is the higher, as the maximum filter output value; and determining the filter output having the least positive or most negative output value after scaling, whichever is the lower, as the minimum filter output value.

The ratio of each rise time constant to its corresponding fall time constant may be equal to an asymmetry factor.

The plurality of non-linear filters may comprise a first set and a second set, the ratio of each rise time constant to its corresponding fall time constant in the first set is equal to a first asymmetry factor, and the ratio of each rise time constant to its corresponding fall time constant in the second set is equal to a second asymmetry factor which is less than the first asymmetry factor.

The first set and the second may set each comprise from 4 to 8 non-linear filters.

The at least one discrete-time recursive filter may comprise a non-linear filter comprising first and second component linear filters, each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to: compare each filter input of the sequence with the filter output of the preceding iteration; and use the second component linear filter when the filter input is lower than the filter output of the preceding iteration, otherwise use the first component linear filter.

Using the second component linear filter when the filter input is lower than the filter output of the preceding iteration, otherwise using the first component linear filter, may be the same independent of the sign or polarity of the input.

When the filter input and the filter output are of the same sign, the apparatus may be configured to use the second component linear filter when the magnitude of the filter input is lower than the magnitude of the filter output of the preceding iteration, otherwise use the first component linear filter; and when the filter input and filter output are of the opposite sign, the apparatus may be configured to use the second component linear filter only.

The at least one discrete-time recursive filter comprises a non-linear filter may comprise first and second component linear filters, each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to: compare the present filter output of the first component linear filter with the present filter output of the second component linear filter; and revise the modelled response using the lower filter output as feedback for both the first and second component linear filters.

The at least one discrete-time recursive filter may comprise a further non-linear filter comprising first and second further component linear filters, each of the first and second further component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to: compare the present filter output of the first further component linear filter with the present filter output of the second further component linear filter; and revise the modelled response using the higher filter output as feedback for both the first and second further component linear filters.

The apparatus may be configured to select the lower filter output or the higher filter output, as appropriate, to compare with the actual response of the motor.

The apparatus may be configured to: scale each filter output by a scaling factor; determine, from the scaled filter outputs at each iteration of the sequence, the scaled maximum filter output value and the scaled minimum filter output value; and if the drive signal is positive: compare the actual response of the motor to the scaled minimum filter output value, and identify a motor error if the actual response of the motor is less than the scaled minimum filter output value; or if the drive signal is negative: compare the actual response of the motor to the scaled maximum filter output value, and identify a motor error if the actual response of the motor is greater than the scaled maximum filter output value.

Lower may mean a lower magnitude, and higher may mean a higher magnitude.

The time constants may cover a range of expected motor time responses, at maximal resistive load, over an expected set of inertial loading conditions.

The apparatus may be configured to scale the filter output of the at least one discrete-time recursive filter by a scaling factor prior to comparing the modelled response with an actual response of the motor to the drive signal, the scaling factor representing a steady state loading of the motor.

The steady state loading of the motor may be defined as the ratio in steady state of calculated back-EMF to the drive signal, or the ratio of the steady state motor slow down speed to the maximal speed of the motor. The output of each filter may be scaled by the same scaling factor. The scaling factor may lie in the range from 0.01 to 1, preferably in the range from 0.2 to 0.5.

The at least one discrete-time recursive filter may have unity gain. Unity gain may define a filter that has an output equal to its input in steady state conditions.

The motor error may represent a jam or blockage of the motor.

The apparatus may be configured to: compare the drive signal to a first threshold defining a minimum motor drive signal; and compare the modelled response of the motor with the actual response of the motor to identify a motor error only if the drive signal exceeds the magnitude of the first threshold.

The apparatus may be configured to: determine, based on the drive signal, a second threshold defining a minimum modelled motor response to the drive signal; compare the modelled response of the motor with the second threshold; and if the drive signal is positive: compare the modelled response of the motor with the actual response of the motor to identify a motor error if the modelled response is greater than the second threshold; or if the drive signal is negative: compare the modelled response of the motor with the actual response of the motor to identify a motor error if the modelled response is lower than the second threshold.

The apparatus may be configured to: determine, based on the drive signal, a second threshold defining a minimum modelled motor response to the drive signal; compare the modelled response of the motor with the second threshold; and compare the modelled response of the motor with the actual response of the motor to identify a motor error only if the modelled response exceeds the magnitude of the second threshold.

The modelled response of the motor may be compared with the actual response of the motor only: if the drive signal is positive, the minimum output from the one or more filters is above the second threshold, and if the drive signal is negative, the maximum output from the one or more filters is below the second threshold, otherwise, no comparison is made.

The second threshold may be the drive signal scaled by a factor less than 0.5, preferably a factor in the range from 0.05 to 0.2.

On identification of a motor error, the apparatus is configured to execute a correction procedure, the correction procedure comprising: adjusting the drive signal; modelling a response of the motor to the adjusted drive signal; comparing the modelled response with an actual response of the motor to the adjusted drive signal; and determining that the motor error has been corrected if the actual response of the motor is within the range of expected motor behaviour defined by the modelled response, otherwise repeating the correction procedure.

The correction procedure may further comprise: suspending a user program for the motor before adjusting the drive signal; and reinstating the user program for the motor upon determining that the motor error has been corrected.

The apparatus may be configured to provide an indication of a motor error timeout if the actual response of the motor is outside the range of expected motor behaviour after a predefined time or number of drive signal adjustments.

The apparatus may be configured to adjust one or more of the magnitude, rate of change and polarity of the drive signal with each iteration of drive signal adjustment.

The drive signal may comprise a drive voltage for the motor.

The actual response of the motor to the drive signal may comprise a back electromotive force generated by the motor.

The apparatus may be configured to: monitor the rotation speed of the motor or the current drawn by the motor; and calculate a back electromotive force based on the monitored rotation speed of the motor or the current drawn by the motor as the actual response of the motor.

The apparatus is one or more of a kitchen appliance, a blender, a portable blender, a mixer, a liquidiser, and a module for one or more of the same.

At least one of the motor and the one or more filters may form part of the apparatus.

According to a second aspect, there is provided a method comprising: modelling a response of a motor to a drive signal using one or more filters, the one or more filters configured to define a range of expected motor behaviour associated with the drive signal; comparing the modelled response with an actual response of the motor to the drive signal; and identifying a motor error if the actual response of the motor is outside the range of expected motor behaviour defined by the modelled response.

The method may be repeated at an iteration rate, wherein the iteration rate lies in the range from 100Hz to 1kHz, preferably from 100Hz to 500Hz.

One or more logic conditions for a filter are applicable to another filter where compatible. The optional features described in relation to the apparatus of the first aspect are applicable to the method of the second aspect where compatible.

The steps of any method disclosed herein do not have to be performed in the exact order disclosed, unless explicitly stated or understood by the skilled person.

Corresponding computer programs for implementing one or more steps of the methods disclosed herein are also within the present disclosure and are encompassed by one or more of the described examples.

One or more of the computer programs may, when run on a computer, cause the computer to configure any apparatus, including a battery, circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, examples or features in isolation or in various combinations whether or not specifically stated (including claimed) in that combination or in isolation. Corresponding means for performing one or more of the discussed functions are also within the present disclosure.

Throughout the present specification, descriptors relating to movement such as "forwards", "backwards" or "reverse", as well as any adjective and adverb derivatives thereof, are used in the sense of the movement of features relating to those presented in the drawings. However, such descriptors are not intended to be in any way limiting to an intended use of the described or claimed invention.

The above summary is intended to be merely exemplary and non-limiting.

**Brief Description of the Figures**

A description is now given, by way of example only, with reference to the accompanying schematic drawings, in which:

Figure 1 shows in schematic form an example apparatus.
Figure 2 shows in schematic form an example system.
Figure 3 shows a difference equation block diagram for a single component linear recursive filter comprised by a filter set, according to an example.
Figure 4 shows simulated data for dynamic jam detection using discrete recursive non-linear filters, according to an example.
Figure 5 shows in schematic form another example system.
Figure 6 shows a difference equation block diagram for a single linear recursive filter, according to an example.
Figures 7a-c show difference equation block diagrams for example non-linear recursive filters.
Figure 7d shows example filter scaling equation block diagrams for the example non-linear recursive filters shown in Figures 7b and 7c.
Figures 7e-f show data representing the behaviour of the example non-linear recursive filters shown in Figures 7b and 7c.
Figure 8 shows comparison data from an example linear filter array and example non-linear filters.
Figures 9a-d show further comparison data that relates to the data shown in Figure 8.
Figure 10 shows a flow diagram for a scheduled jam detection process according to an example.
Figures 11a-b show a flow diagram for a scheduled jam detection process according to another example.
Figure 12 shows a flow diagram for a jam correction control process according to an example.
Figure 13 shows a flow diagram for a jam correction control process according to another example.
Figures 14a-b show a flow diagram for a jam correction manoeuvre process according to an example.
Figure 15 shows a flow diagram for a jam correction manoeuvre process according to another example.
Figure 16 shows a flow diagram of a method of identifying a motor error.

**Detailed Description**

General Approach

A motor control system is aware at all times of the level of current flowing into the motor. Using motor theory, it is possible to calculate the speed of the motor using this current information along with the applied voltage and known motor characteristics. This speed information is compared with the extremes of normal behaviour. The extremes of normal behaviour can be determined in a two-stage process:

- Expected behaviour is calculated.
- A margin may be added to the expected behaviour to arrive at the extreme of normal behaviour.

If the motor is determined to be operating outside the 'extremes of normal behaviour' in such a way that it is 'slower', a jam is signalled to be present. A margin may be added such that anything beyond the margin is considered to be an unacceptable overload.

The expected behaviour may be calculated using a filter, which takes account of the fact that the motor takes time to spin up to speed, or to change to a new speed.

Methods described herein utilize a dynamic threshold, which takes account of not only the present drive voltage to the motor but also all previous values, optionally via a recursive non-linear filter set. With this approach, the determination of a jam condition is sufficiency accurate to allow immediate reporting of a detected jam condition. The insertion of a timer, with a timeout set to account for all foreseen eventualities, is not required.

The result is jam/overload detection response times that are significantly reduced, and the elimination of potential detection failure when the drive signal is highly dynamic.

In other words, the trigger condition for the current is not fixed and predetermined. In examples described further below, the trigger condition is live and determined by passing voltage information (representing the drive to the motor) into a filter or filter set. The output from the filter or filter set, after further processing described further below, represents the expected worst case back-EMF of the motor (i.e., its internally generated voltage as if it were acting as a generator). The back-EMF of the motor relates closely to the speed of the motor (having direct proportionality in a simple motor model with permanent magnets), which in turn depends on both the drive to the motor and its load characteristics.

The term 'further processing' is used herein to refer to the possible scaling of the filter output and the selection of maximum or minimum filter output values, in order to determine the worst case back-EMF.

In these examples, the expected worst case back-EMF is compared with the actual back-EMF that is determined by direct calculation. If the actual back-EMF is 'worse' that the 'expected worst' then a jam condition is flagged. Methods disclosed herein thus compare an internally generated motor voltage with its worst expected value for the no-jam state.

The filter used may be a single pole recursive filter having a time constant that relates to the time constant for the motor to reach approximately 63.21% (i.e., $1 - e^{-1}$ expressed as a percentage) of its terminal speed. The output of the filter may be scaled by a quantity 'k' which reflects how much loading on the motor is tolerated. A scaling factor of 0.5, for example, means that the point where the motor is slowed down to below half its no-load speed is not tolerated.

The methods may be adapted for a range of drive signal magnitudes to a motor, and/or to different drive signal polarities or drive signal rates of change.

The robustness of these methods is well suited to systems that attempt to alleviate a jam condition (jam correction) using motor manoeuvres. Evasive action can be attempted at an earlier point in time, with no restriction as to the nature of the motor manoeuvres. Such manoeuvres can be highly dynamic, including reverse drive at a high repetition rate, without degrading the sensitivity of the jam detection system.

The jam detection system can remain fully operational while evasive motor manoeuvres are taking place, ensuring that the correction process can decide to cease corrective manoeuvres at an appropriate point. This speeds up the jam correction process, by both avoiding repetitive entry into the correction process and avoiding execution of this process for a time that is longer than necessary.

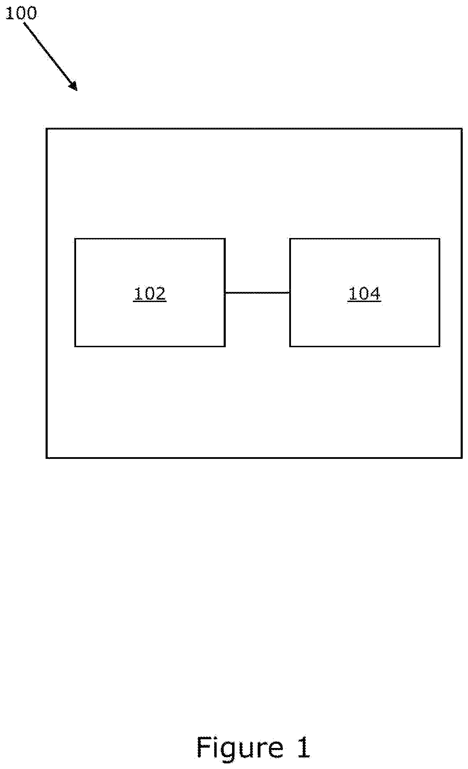

Figure 1 shows in schematic form an example apparatus 100. The apparatus 100 comprises at least one processor 102 and at least one memory 104 including computer program code. The at least one memory 104 and the computer program code configured to, with the at least one processor 102, cause the apparatus 100 to: model a response of a motor to a drive signal using one or more filters, the one or more filters configured to define a range of expected motor behaviour associated with the drive signal; compare the modelled response with an actual response of the motor to the drive signal; and identify a motor error if the actual response of the motor is outside the range of expected motor behaviour defined by the modelled response.

The one or more filters may comprise at least one discrete-time recursive filter configured to receive a sequence of filter inputs indicative of drive signals forming part of a drive operation, and generate a plurality of respective filter outputs defining the associated modelled response of the motor, and wherein the apparatus 100 is configured to iteratively revise the modelled response with each filter input of the sequence, using the filter output of the preceding iteration as feedback.

The sequence may be received over intervals of time. The one or more filters may comprise at least one non-recursive filter. The one or more filters may have unity steady state gain. The one or more filters may be low pass filters. The expected motor behaviour may reflect the expected behaviour of the motor at maximum allowable loading. The modelled response may be the worst-case rotational velocity of the rotor, equivalently the worst-case calculated back-EMF from the motor.

## Dynamic Jam Detection using Discrete Recursive Non-Linear Filters

The underlying theory makes use of a simple permanent magnet DC motor model which consists of an ideal DC motor in series with a resistor. The resistor represents the internal resistance of the motor windings. Ripple current in the motor windings is assumed to be sufficiently small, so as to render the effect of internal motor inductance negligible. Electrical inductance is therefore not included in the model.

The use of such a model allows the straightforward calculation of the motor back-EMF, once the motor current, drive voltage and resistance are known. The motor back-EMF is the theoretical voltage generated by the ideal motor as if it were a generator.

In an example, during motor operation the current to the motor is continually monitored. Using the simple motor model, this current is used to calculate the theoretical back-EMF of the motor for each point in time.

For the motor model used, back-EMF is proportional to the motor RPM. It may be calculated from the RPM by the equation $back\text{-}EMF = RPM / K_v$. The quantity $K_v$ in this example is a constant for the motor and represents the RPM per volt of applied voltage.

The back-EMF may also be calculated using the formula $back\text{-}EMF = V_m - I_m X R_m$, where $V_m$ is the voltage applied to the motor, $I_m$ is the current passing to the motor (in the associated direction), and $R_m$ is the winding resistance. The back-EMF may be a negative quantity, which indicates that the motor is rotating in a direction opposite to that associated with the applied voltage.

Assuming a constant load (fixed resistance and rotational inertia), when applying a fixed voltage to a motor which is initially at rest, its RPM and hence back-EMF increase exponentially. Because this is an exponential rise, it can be defined by a time constant '$\tau$' which represents the time taken for the rotor to spin up to approximately 63% of its terminal value. This mechanical time constant is dependent on the rotational inertia of the motor's rotating parts, the rotational resistance, the internal resistance of the winding, and effective electrical resistance of the drive mechanism, which supplies the motor with power.

The method may utilise a plurality of filters that accurately represent the motor being employed in the system. A first order linear low pass filter may be used. Such a filter has an exponential output response to a stepped input and has a rise time that is equal to the fall time. In reality the rise and fall times of a real motor are usually not the same, and these two values can vary significantly. In order to model this asymmetry in real motor behaviour, the filters may have asymmetric rise and fall times, rendering them non-linear. This is achieved by simply switching the filter coefficients, dynamically, depending on whether or not the magnitude of the input is greater or less than the magnitude of the previous output, for a unity gain filter. In addition, all filter scaling is performed after this comparison.

The difference in rise and fall times may be represented by an asymmetry factor $\psi = rise\ time / fall\ time$. The asymmetry factor can be determined by direct motor rpm measurement and is likely to vary with the chosen conditions. Once a set of value(s) are determined over a range of conditions, the quantities $\psi_1$ and $\psi_2$ are set to encompass these values. The value of $\psi_1$ is set such that $\psi_1 \geq \psi_2$. $\psi_1$ and $\psi_2$ represent the boundary of all values that may exist in the real motor when operational.

In an example, the filters used in the detection process are split into two sets, set 1 and set 2. Filter set 1 has an asymmetry factor of $\psi_1$, and filter set 2 has an asymmetry factor of $\psi_2$. There are 'N' filters in set 1 and 'M' filters in set 2. The rise and fall times of each filter is set to encompass all possible rpm rise and fall times for the motor when operational. A motor with a lower inertial load will have a faster fall and rise time, than one with a higher inertial load. The rise and fall times are set from measured motor data over all anticipated loading in normal use. Averaged values for rise and fall time may range from 5ms to 80ms.

The value of 'N' may be chosen between 4 and 8 (inclusive). The value of 'M' may also be chosen between 4 and 8 (inclusive). Other values are possible. The value of 'N' may be equal to 'M'. The value of 'M' may be set to zero if the real motor rotates in the one direction only. Larger values for 'N' and 'M' will yield higher detection accuracy, but with diminishing returns on jam detection time.

All filters may have the same gain value 'k' applied to their outputs. This is set to a value that represents the maximum allowable rpm slowdown of the motor, expressed as a factor, below which a jam would be deemed to be present. This would typically be in the range from 0.25 to 0.40. A value of 0.5 represents a motor slowdown of 50%, which for a simple motor model represents the point of maximal power transfer from the motor to the load. A value of 0.25 represents a slowdown of 75%, at which point the motor would be operating at very low efficiency. Motors ideally operate with a factor slowdown of between 0.5 and 1.

A specific rise time is denoted by the quantity '$\tau$'. The total number of non-linear filters is 'N' plus 'M'.

All filters receive the same signed input value. This input represents the drive to the motor and is proportional to the applied voltage. A negative value represents a reverse drive to the motor. The units used are the same as those used to calculate the motor back-EMF.

In the jam detection process all filter outputs are reduced to just two values, the maxima y[n]max and the minima y[n]min. The maxima y[n]max is the most positive or least negative output value in the set, whichever is the higher. The minima y[n]min is the least positive or most negative output value in the set, whichever is the lower. The value 'n' is the sample number in the sequence.

The filters are implemented as discrete time difference equations, which may be executed iteratively. The filter iteration rate may be set to be sufficiently high to allow accurate representation of the motor input drive. The filter iteration rate may lie in the range from 100Hz to 1kHz, preferably from 100Hz to 500Hz.

The current passing to the motor may be measured at each iteration, in which case the motor back-EMF is calculated at each iteration, in the same units of measurement used for the data passing to the filters.

Subject to operational thresholds, at each iteration, which determine if the detector is active, the scaled filter maxima or minima are compared to the calculated motor back-EMF, to determine if a jam condition exists. These operational thresholds can be dispensed with, however, and may also only be implemented in part. If the detector is active and a jam condition exists, an associated flag is set true. If the detector is active and if a jam condition does not exist, the associated flag is set false. While the detector is inactive, the flag is not updated.

Accordingly, in an example in which the drive to the motor is positive (the input to the filter array is positive), the detector is active if the following criteria are met:

- The drive to the motor is above a pre-determined positive threshold '+DMin'. The value of '+DMin' may be fixed or may be dynamically calculated. The value of '+DMin' may be 20% of the maximum possible applied voltage (fixed in this example).

- The scaled filter set minima y[n]min is above a pre-determined positive threshold 'Y_Min'. The value of 'Y_Min' may be fixed or may be dynamically calculated. The value of 'Y_Min' may be 10% of the applied voltage (dynamic in this example).

In an example in which the drive to the motor is negative (the input to the filter array is negative), the detector is active if the following criteria are met:

- The drive to the motor is below a pre-determined negative threshold '-DMin' (the negative of Dmin).

- The filter set maxima y[n]max is below a pre-determined negative threshold '-Y_Min' (the negative of Y_Min). The value of 'Y_Min' may be 10% of the magnitude of the applied voltage (dynamic in this example).

In an example in which the drive to the motor is positive (the input to the filter array is positive) a jam exists if the following criteria are met:

- The detector is active.
- The calculated and signed motor back-EMF is less than the filter minima.

In an example in which the drive to the motor is negative (the input to the filter array is negative) a jam exists if the following criteria are met:

- The detector is active.
- The calculated and signed motor back-EMF is greater than the filter maxima.

Deciding on the use of the fall time or the rise time

The fall time is used when the magnitude of the output is reducing. The rise time is used when the magnitude of the output is increasing. To ensure the validity of these rules the sign (polarity) of the filter input and filter output must be accounted for. In other words, simply looking at the magnitude of these quantities may result in the introduction of discrepancies in jam detection.

For example, if the filter input is +1 and the filter output is -0.5, a fall time is selected because the magnitude of the output would be reducing to zero.

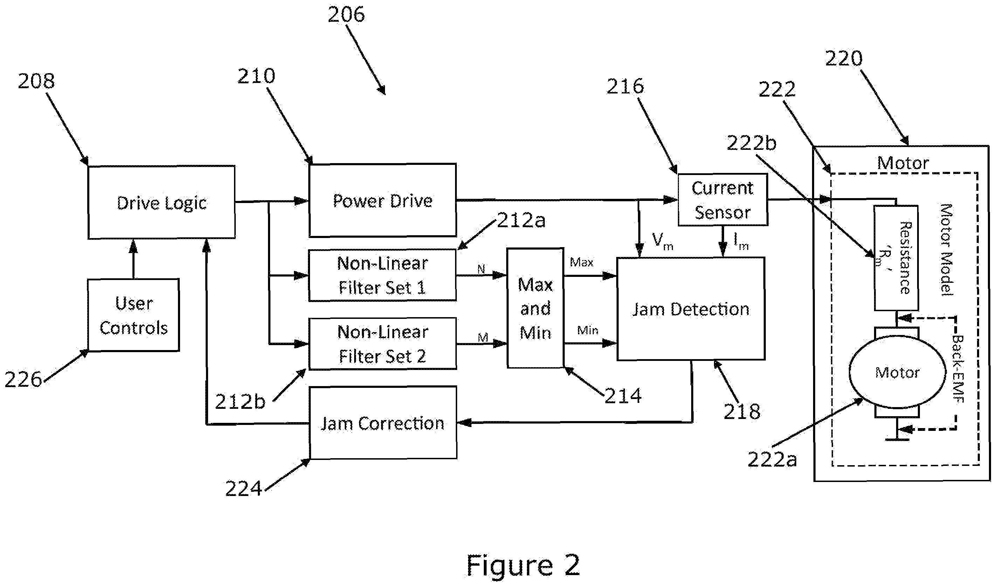

Figure 2 shows in schematic form an example system 206 generally configured to implement the above process.

The system 206 comprises: drive logic 208, which responds to a user selection, and any requests for anti-jam correction processes; a power drive module 210, which generates the motor drive voltage requested by the drive logic 208. The power drive module 210 is capable of generating both positive and negative voltages and ramping between specified values at a specified rate. Once the target voltage is reached, this state is communicated back to the controlling process.

The system 206 further comprises: non-linear filter sets 1 and 2, 212a-b, which are the discrete non-linear filter sets having asymmetry factors $\psi 1$ and $\psi 2$, respectively; max and min 214, which represent the maximum and minimum values at each iterative cycle; a current sensor 216 and a jam detection stage 218, wherein current sensor 216 converts the current to the motor into a readable signal for use by the jam detection stage 218, and the jam detection stage 218 processes the applied motor voltage, motor current and filter maxima and minima (to which scaling is subsequently applied) to detect a jam condition; a physical motor 220; and a motor model 222 used in the analysis, comprising an 'ideal' motor 222a in series with a resistor 222b that represents the internal resistance of the motor windings.

The system 206 further comprises one or more optional features: a jam correction module 224; and user controls 226. The jam correction module 224 comprises logic (not shown) that is responsible for jam correction. The user controls 218 allow a user to interact with the system and may allow the user to access internal motor control programs which are designed to perform particular tasks.

It will be appreciated that the system 206 can be realized as a combination of software and hardware, such that notionally separate features, such as non-linear filter sets 1 and 2, 212a-b, are implemented within a single module or program, optionally in combination with one or more other features of the system.

Each non-linear filter is a discrete unity gain recursive first order low pass filter, with dynamically switchable coefficients. The equation set is given below:

$$y[n] = a[n] *x[n] + b[n]*y[n-1] \quad (1)$$
$$\psi = \tau 1 / \tau 2$$

If magnitude (x[n]) > magnitude (y[n-1]) then:

$$a[n] = 1 - e^{-T/\tau 1} \quad (2);$$

$$b[n] = e^{-T/\tau 1} \quad (3)$$

Else

$$a[n] = 1 - e^{-T/\tau 2} \quad (4);$$

$$b[n] = e^{-T/\tau 2} \quad (5).$$

Equation (1) is the filter difference equation which is executed iteratively. The terms 'x[n]' and 'y[n]' are the sequence input and output respectively. The quantities 'a' and 'b' are the dynamically switched coefficients of the filter. The quantity 'n' is the data sequence number. The parameter '$\tau 1$' is the exponential rise time of the filter in seconds. The parameter '$\tau 2$' is the exponential fall time of the filter in seconds. $\psi$ is the asymmetry factor, defined as $\psi = \tau 1 / \tau 2$. The quantity 'T' is the sample time period in seconds. The constant 'e' is the natural number, 2.718....

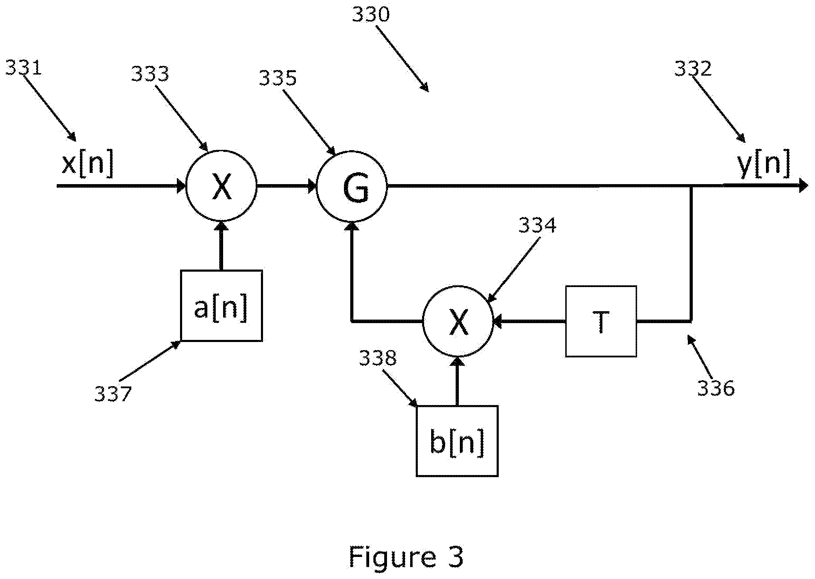

Figure 3 shows a difference equation block diagram for a single component recursive filter 330 comprised by a filter set, according to an example. The single component recursive filter 330 is configured to receive a filter input 331 and to provide a filter output 332. The single component recursive filter 330 comprises multiplier units 333, 334, a summation unit 335, and a recursion loop 336. The single component recursive filter 330 applies, as first 337 and second 338 dynamically switchable coefficients, the quantities 'a' and 'b' as discussed in relation to equations (1)-(5). These dynamically switchable coefficients render the resultant filter behaviour non-linear.

To determine the worst case back-EMF, further processing may be applied. This may involve determining the filter maxima and filter minima, and scaling by a quantity (factor) 'k'.

The Time Constant Array

The plurality of linear filters, each having a respective time constant for use in revising the modelled response, gives rise to a time constant array that represents an array of time response possibilities. It is not known which filter response may apply in any given instant in time and so the response from all filters is considered.

To implement the model, it is necessary to determine the maximum and minimum time constants that may exist within the system to be modelled. In an electro-mechanical system, the response times (time to a pre-determined percentage of terminal speed) are dependent on two factors, namely the rotational mass of the moving parts (inertial load), and the resistance to movement within the system (resistive load). The resistance to movement in the system or 'system resistance' is made up of both mechanical resistance and electrical resistance from the drive system.

If the rotational inertia is large, then the resultant time constants will also be large. If the rotational resistance is large, then the resultant time constants will be smaller.

When a motor drives a load, that added load may not necessarily significantly affect the time constant of the system. As such, both the resistive and inertial properties of the load need to be considered to determine a meaningful time constant.

To this end, when determining the maximum and minimum time constant for the system, either practical measurements need to be taken with a range of loads, or measurements taken with no load and the effect of the load applied mathematically, after making assumptions.

Where the added load is not rotationally 'locked' to the drive, for example with a fluid load, then the 'added' rotational inertia is taken to be the best approximation to a single order system. In this situation, adjustments may be required to optimise actual performance.

In a blender environment, for example, the DC motor without vessel loading will have a high rotational inertia relative to mechanical resistance. Mechanical resistance is deliberately kept low to improve the efficiency of the system. The fluid load that is added to the apparatus would typically have a low contribution to rotational inertia (first order approximation), but a high contribution to rotational resistance. The addition of the fluid load is therefore expected to reduce the time constant of the system and not increase it.

In an example, the motor has an average time constant of 42ms when tested with no load. The measured asymmetry factor is 0.60, giving a rise time of 31ms and a fall time of 51ms. The applied load modifies the average time constant from 42ms to a range of 14 to 80ms. The value of 14ms is arrived at after taking account the effect of the maximum permissible resistive loading. These values form the basis for setting the rise and fall times within the detector. The values used for the detector do not have to precisely equal the values determined from practical measurement. Further adjustment may be made to these values to optimise the performance of the detector. For example, a detector deemed to be initially too sensitive to motor error detection may benefit from increasing the upper average time constant from 80ms to 100ms.

Asymmetry Factor

The asymmetry factor is the ratio of the rise time to the fall time. This is a property of the motor and so a load does not necessarily need to be applied when taking measurements. The measurements should be taken using the intended drive source. Once an average factor is found for the motor this value is bracketed to produce a higher and a lower value. The degree of bracketing will alter the sensitivity of the system to detecting a jam when exposed to dynamic conditions. Practical adjustments may be required to produce an optimal model performance.

Taking the above example of an asymmetry factor of 0.60 and a mean range of 14ms to 80ms, the asymmetry factor of 0.6 could be bracketed to 0.45 and 0.75. Both these values skew the modelled motor speed to a higher average value in the presence of a rapidly changing dynamic drive.

The above discussion exemplifies the at least one discrete-time recursive filter comprising a plurality of linear filters each having a respective time constant for use in revising the modelled response, the respective time constants defining the time taken by the motor to reach a predefined percentage of terminal speed under different load conditions for expected motor behaviour.

The at least one discrete-time recursive filter may comprise a non-linear filter having longer and shorter time constants for use in revising the modelled response, the longer and shorter time constants defining the time taken by the motor to reach a predefined percentage of terminal speed under a range of load conditions for expected motor behaviour, and wherein the apparatus 100 is configured to: compare each filter input of the sequence with the filter output of the preceding iteration; and when the filter input and the filter output are of the same sign, switch from the longer time constant to the shorter time constant when the magnitude of the filter input is lower than the magnitude of the filter output of the preceding iteration, otherwise use the longer time constant, and when the filter input and filter output are of the opposite sign, use the shorter time constant only.

The at least one discrete-time recursive filter may comprise a non-linear filter having rise and fall time constants for use in revising the modelled response, the rise and fall time constants defining the time taken by the motor to accelerate and decelerate to respective predefined percentages of terminal speed under a predefined load condition for expected motor behaviour, and wherein the apparatus 100 is configured to: compare each filter input of the sequence with the filter output of the preceding iteration; and when the filter input and filter output are of the same sign, switch from the rise time constant to the fall time constant when the magnitude of the filter input is lower than the magnitude of the filter output of the preceding iteration, otherwise use the rise time constant; and when the filter input and the filter output are of the opposite sign, use the fall time constant only.

The rise and fall time constants may be the same or different.

The rise time constant and the fall time constant may each lie in the range from about 5ms to about 80ms.

The predefined percentage of terminal speed for a load condition may be $100 \times (1 - e^{-1})$. All rise and fall time constants may be measured using the factor $(1 - e^{-1})$.

The at least one discrete-time recursive filter may comprise a plurality of non-linear filters, each non-linear filter having associated rise and fall time constants for use in revising the modelled response, the associated rise and fall time constants defining the time taken by the motor to accelerate and decelerate to respective predefined percentages of terminal speed under a predefined load condition for expected motor behaviour, and wherein the apparatus 100 is configured to: scale each filter output by a scaling factor; determine, from the scaled filter outputs of the plurality of non-linear filters at each iteration of the sequence, the scaled maximum filter output value and the scaled minimum filter output value; and if the drive signal is positive: compare the actual response of the motor to the scaled minimum filter output value, and identify a motor error if the actual response of the motor is less than the scaled minimum filter output value; or if the drive signal is negative: compare the actual response of the motor to the scaled maximum filter output value, and identify a motor error if the actual response of the motor is greater than the scaled maximum filter output value.

Determining the maximum and minimum scaled filter output values may comprise: determining the filter output having the most positive or least negative output value after scaling, whichever is the higher, as the maximum filter output value; and determining the filter output having the least positive or most negative output value after scaling, whichever is the lower, as the minimum filter output value.

The ratio of each rise time constant to its corresponding fall time constant may be equal to an asymmetry factor.

The plurality of non-linear filters may comprise a first set and a second set, the ratio of each rise time constant to its corresponding fall time constant in the first set is equal to a first asymmetry factor, and the ratio of each rise time constant to its corresponding fall time constant in the second set is equal to a second asymmetry factor which is less than the first asymmetry factor.

The first set and the second may set each comprise from 4 to 8 non-linear filters.

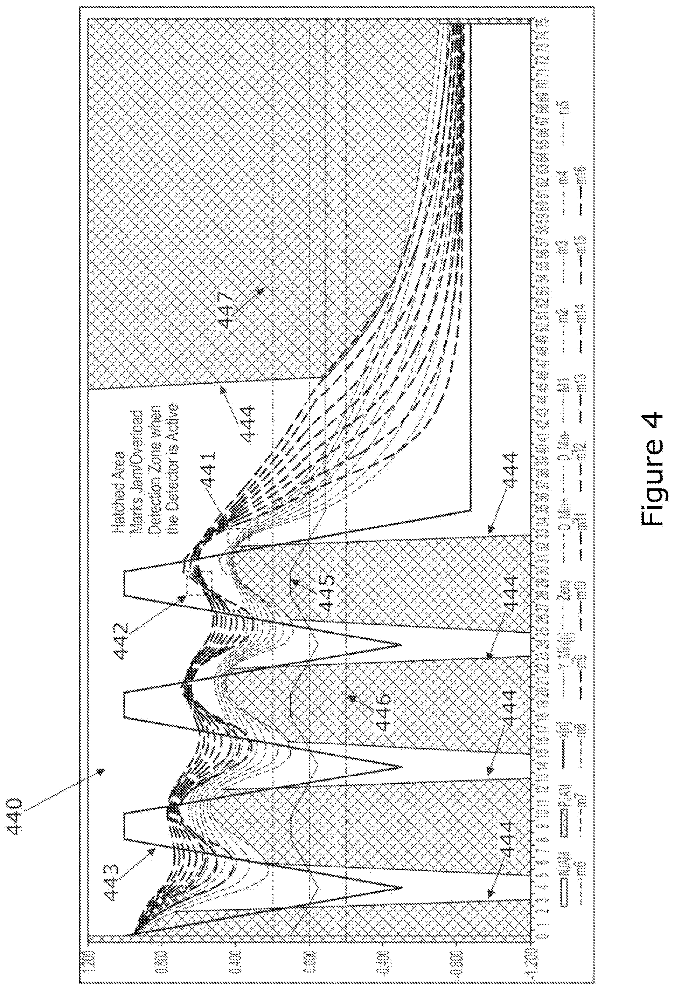

Figure 4 shows simulated data 440 for dynamic jam detection using discrete recursive non-linear filters, according to an example. Specifically, the simulated data 440 show the response of two filter sets to a dynamic motor drive signal.

In this example there are 8 filters in filter set 1 and 8 filters in filter set 2. The filter-set gain has been set to 0.95 for ease of illustration. This increases the visible area of jam detection. The start conditions are a normalised drive of '1' with the filters settled.

The iteration rate is set to 200Hz, and the average filter fall/rise times are set from 25ms to 80ms with equal spacing (raise time plus fall time divided by 2). The quantity $\psi 1$ (for filter set 1) is set to 1.25 and the quantity $\psi 2$ (for filter set 2) is set to 0.75. The x-axis iridicates the iteration number starting at 0. The output traces from filter set 1, m1-m8 and indicated by reference sign 441, are marked in red and the output traces from filter set 2, m8-m16 and indicated by reference sign 442, are marked in green.

The input drive 443, x[n], is marked in solid orange. As shown, the input drive 443 initially drops to a value of -0.5 (reverse drive) and returns to 1 in 8 iterations. This is repeated twice, before the input drive drops to settled -0.75 for the remainder of the simulation.

The shaded areas 444, PJAM, represents the areas of jam detection. If the back-EMF of the motor is found to be in this region the jam flag is set 'true' to indicate the presence of a jam.

Also shown in Figure 4 are the filter set minimum threshold for detection 445, Y_min [n], and the predetermined positive and negative thresholds 446, 447, -DMin and +Drnin.

The red traces indicated by reference sign 441 and with an asymmetry value $\psi 1$ of 1.25 (higher) can be seen to skew in a downwards direction. This is because is rise time is longer than the fall time. The green traces indicated by reference sign 442 and with an asymmetry value $\psi 1$ of 0.75 (lower) can be seen to skew in an upwards direction. This is because the rise time is shorter than the fall time.

Over iterations 0 to 33, filter set 1 - the traces indicated by reference sign 441 - defines the detection boundary. Despite a repetitive reversing drive the motor remains travelling in a forward direction. Over iterations 47 to 55, filter set 2 - the traces indicated by reference sign 442 - defines the detection boundary. This happens only when the motor is reversing in direction. This is caused by the slower fall time of filter set 2. Over iterations 56 to 75, filter set 1 again defines the detection boundary, as its slower rise time dominates.

Dynamic Anti-Jam Detection using a Discrete Recursive Non-Linear Filter

The underlying theory follows that of Dynamic Jam Detection using Discrete Recursive Non-Linear Filters.

A discrete recursive, single pole, low pass filter has an exponential rise in response to a step input. It is also characterised by a time constant '$\tau$' which represents the time taken for the filter output to attain approximately 63% of its terminal value. This characteristic makes the filter promising for modelling motor behaviour.

The filter for anti-jam detection comprises two discrete recursive single pole, low pass filters. Each filter may have unity gain in steady state and is characterised by a single quantity '$\tau$' which is the filter rise time expressed in seconds. In response to a step input each filter will produce an exponential output of rise time '$\tau$'.

Both filters are given the same input, which is the input drive voltage to the motor. This allows each filter to be configured such that its corresponding output represents each extreme of normal motor behaviour. One filter characterises the slowest rpm response expected from the motor in normal conditions. This would typically be an accelerating motor under heavy load conditions. The rotational inertia of the load would 'add' to the rotational inertia of the motors rotating parts, to give an expected upper maximum rotational inertia. The other filter characterises the fastest rpm response expected from the motor in normal conditions. This would typically be a decelerating motor under no load conditions. Conditions of deceleration would be such that power from the motor is transferred back do the drive system, in a braking mechanism.

The component filter outputs are combined to form a single filter output. The output from the filter, optionally after scaling, represents the worst case back-EMF voltage, below which a jam/overload condition is flagged.

The scaling factor 'k', that may be applied to the filter output is chosen to represent the threshold for acceptable motor loading. A value of k=0.5, represents a back-EMF that is half the applied voltage at the detection threshold. This is the point of maximum power transfer and an efficiency of 50% in a simple motor model. A suitable value of 'k' in a practical system would be around 0.35. At this value, the motor is only 35% efficient with most of the input energy is being converted to heat in the windings.

During motor operation the current to the motor is continually monitored. Using the simple motor model, this current is used to calculate the theoretical back-EMF of the motor. This value is compared directly with the scaled output from the filter, which represents the worst acceptable back-EMF. If the actual back-EMF is less than the worst-case back-EMF as determined by the filter output, a jam/overload condition is flagged.

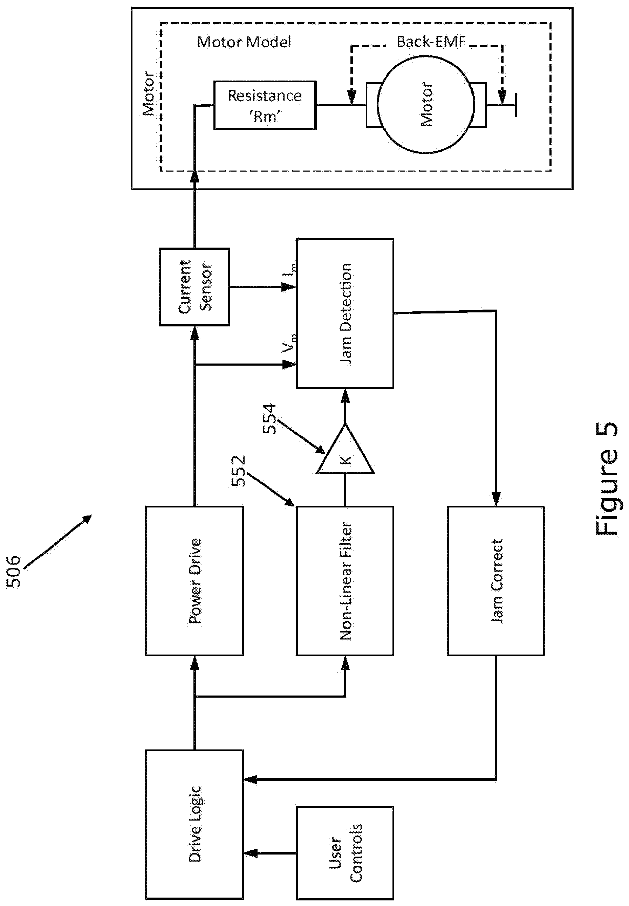

Figure 5 shows in schematic form another example system 506 generally configured to implement the above process.

The system 506 is comparable to the system described with respect to Figure 2 and shares like components such as drive logic and a jam detection module. Alternative features include a non-linear filter 552, which is the discrete non-linear filter that generates the non-scaled worst case back-EMF threshold; and the scaling factor 554, K, for the non-linear filter. As such, it will be appreciated that the system 506 can also be realized as a combination of software and hardware, such that notionally separate features are implemented within a single module or program.

The non-linear filter contains two linear 'component' filters. The equation set for a single linear recursive filter is given below:

$$y[n] = a*x[n] + b*y[n-1] \quad (6)$$

$$a = 1 - e^{-1/d} \quad (7)$$

$$b = e^{-1/d} \quad (8)$$

$$\tau = d*T \qquad (9)$$

Equation 6 is a difference equation. Equations 7 and 8 determine the scaling quantities 'a' and 'b'. The filter in this example has a low pass gain of 1 by design. The quantity 'τ' is the exponential rise time of the filter in seconds. The quantity 'd' is the exponential rise time expressed in sample periods. The quantity 'T' is the sample time period in seconds. The constant 'e' is the natural number, 2.718....

The quantity 'x[n]' is the filter sequence input, where 'n' represents the sequence number. Similarly, the quantity 'y[n]' is the filter sequence output where 'n' represents the sequence number. The quantity 'y[n-1]' is the filter output delayed by one iterative cycle. The iterative cycle delay is equal to 'T' seconds.

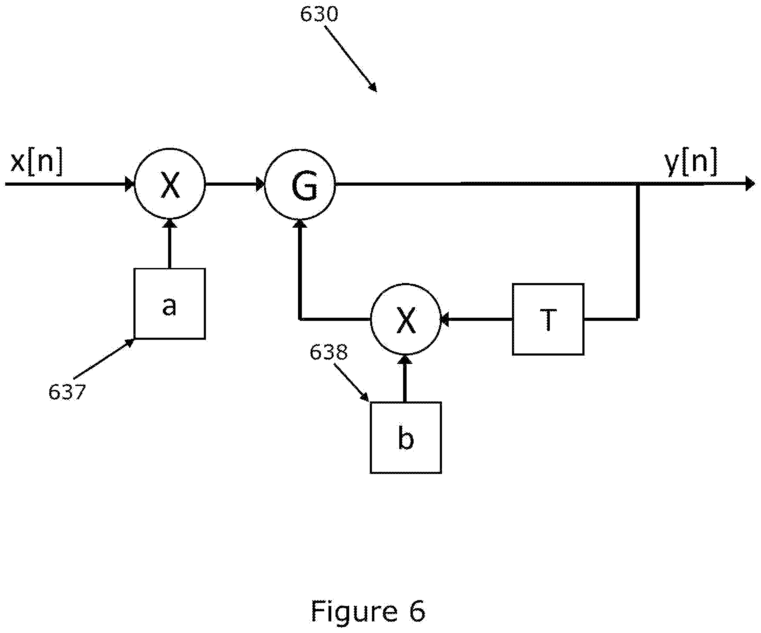

Figure 6 shows a difference equation block diagram for a single linear recursive filter 630, according to an example. The design of the single linear recursive filter 630 is similar to the design of the single component linear recursive filter described with reference to Figure 3. A difference, however, is that the single linear recursive filter 630 applies, as first 637 and second 638 coefficients, the quantities 'a' and 'b' as discussed in relation to equations (6)-(9). These quantities are time invariant ensuring that the filter's behaviour is linear.

The discrete recursive non-linear filter is formed by combining outputs of two such filters via conditional logic to form a single output. The conditional logic will select either the first or the second filter output as the main output depending on either their signed or absolute values. This single output is used as feedback to both filters. When the coefficients 'a' and 'b' of the first filter differ to that of the second filter, the resultant filter behaviour is non-linear.

If utilising just a single non-linear filter to calculate the worst case back-EMF, the conditional logic will compare the absolute output values of each component linear filter. With this approach, one component filter is set to the rise time and the other to the fall time, such that the rise time is longer than the fall time.

When the coefficients are set appropriately the scaled output of the filter will represent the lowest back-EMF acceptable (and thus lowest acceptable rpm) for the corresponding point in time for all reasonably anticipated loads.

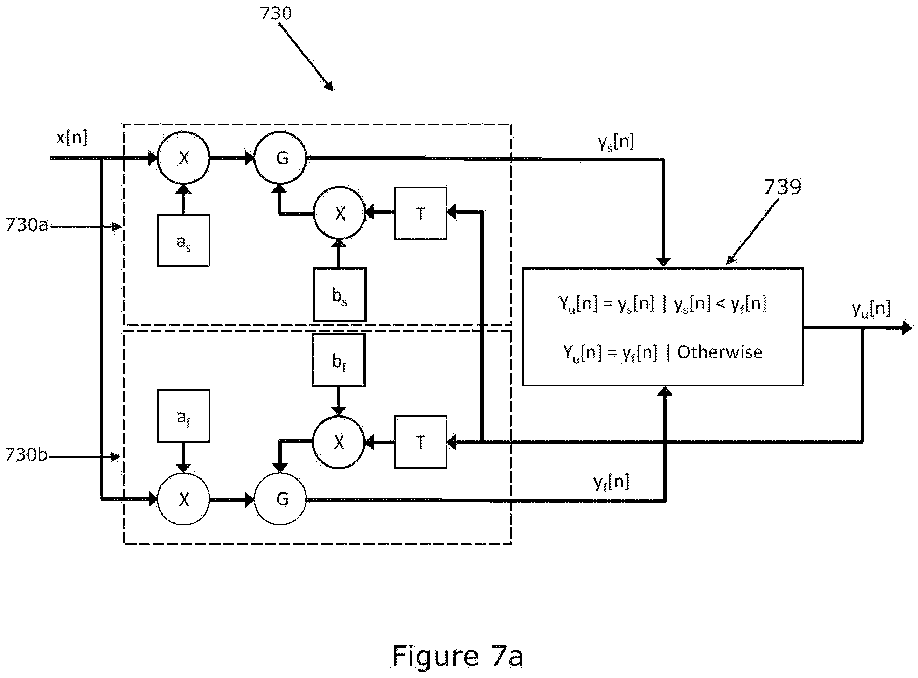

Figures 7a-c show difference equation block diagrams for example non-linear recursive filters, which build upon the above discussion. In Figure 7a, the non-linear recursive filter 730 comprises first 730a and second 730b component linear filters, and a conditional feedback module 739.

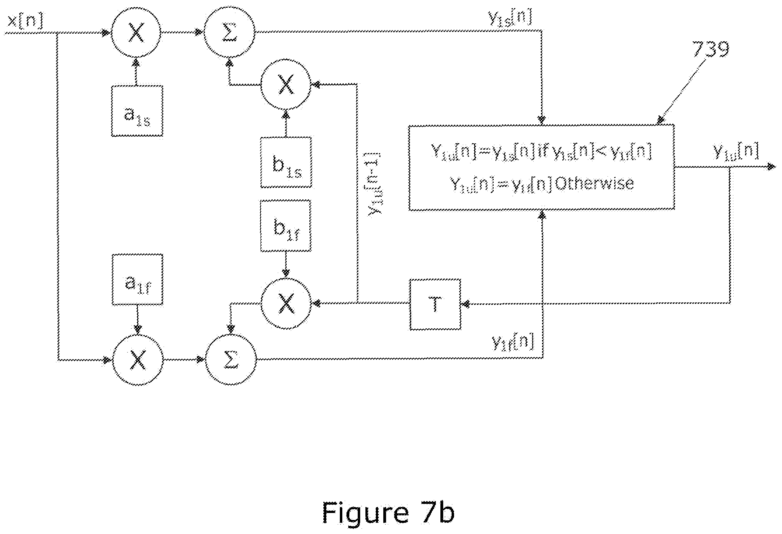

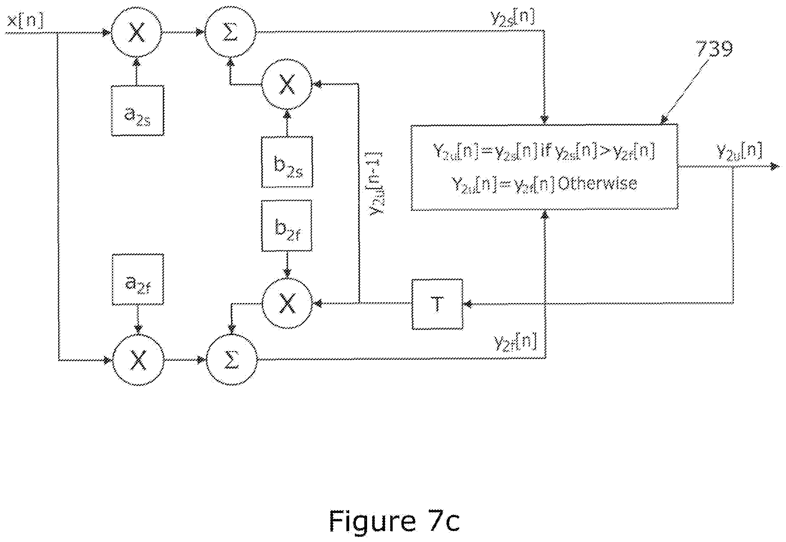

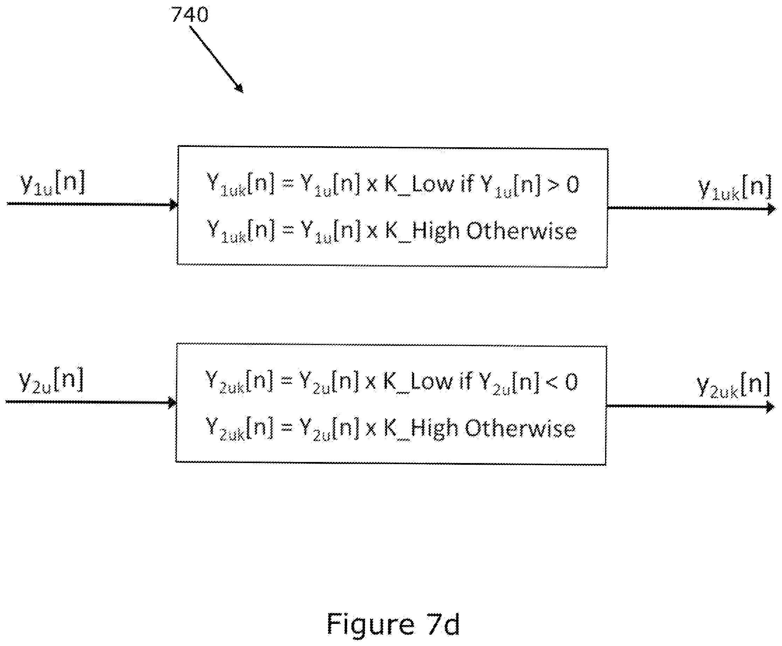

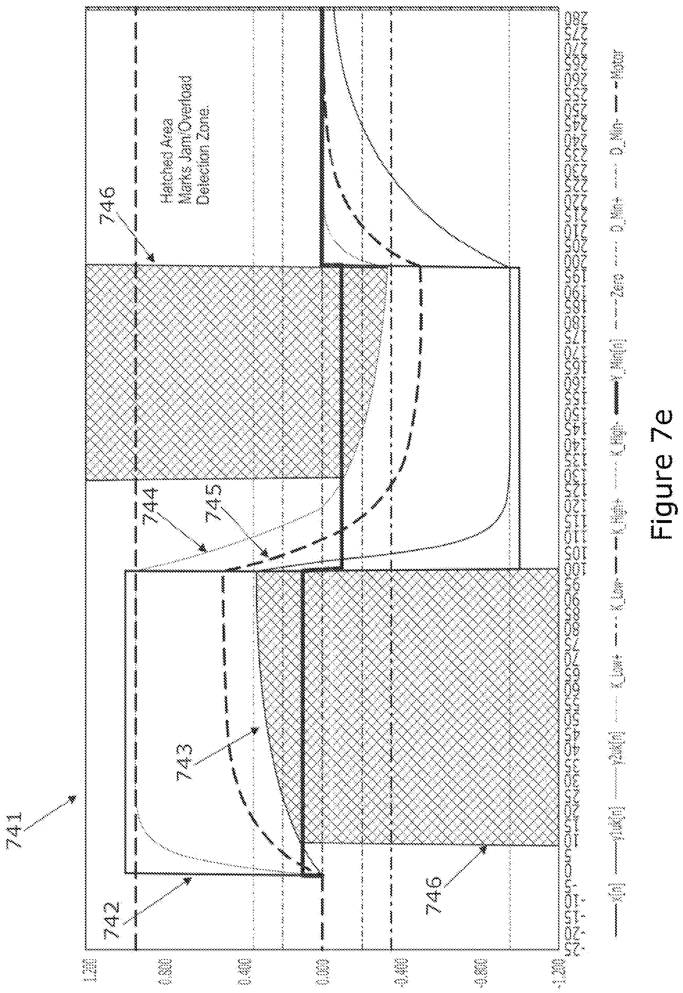

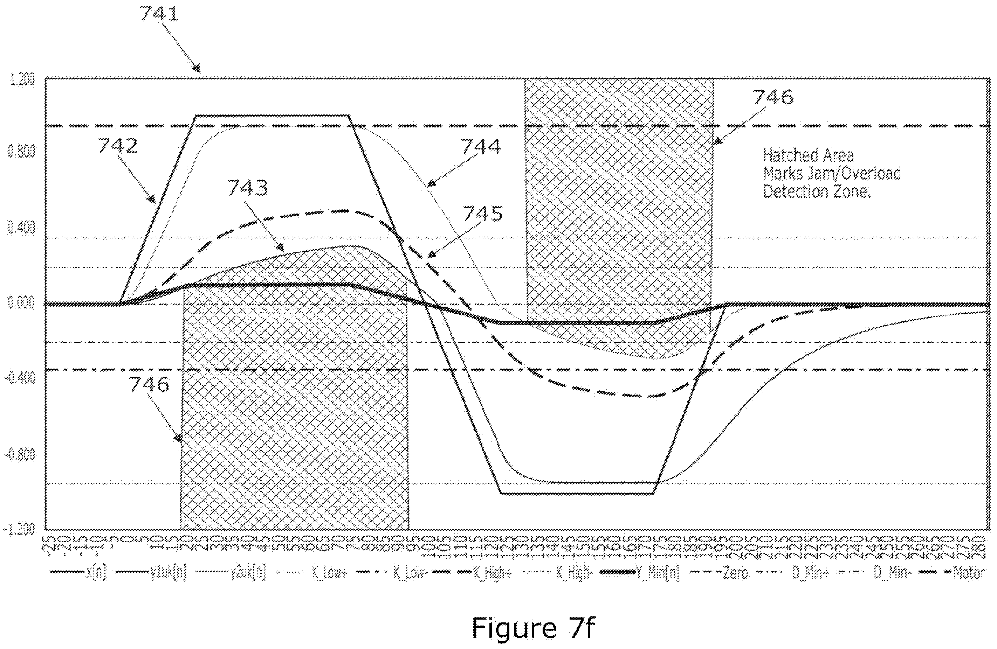

In the filter design shown in Figure 7, 'x[n]' is the filter input, 'y_s[n]' is the slow filter output, 'y_r[n]' is the fast filter output, 'y_u[n]' is the unified (non-linear) filter output, 'a_s' is the slow filter 'a' constant, 'b_s' is the slow filter 'b' constant, 'a_f' is the fast filter 'a' constant, 'b_f' is the fast filter 'b' constant. The remaining components are as described with respect to Figure 3 and 6.

In an example, the filter iteration rate is 100Hz. The quantity 'T', which is the time between iterations, would then be 10ms. For the slow filter, 'd' is set to 10 and 'τ_s' (the slow time constant) would then be 10 x 10ms = 100ms. Accordingly, it would take 100ms to attain 63.2% of the filter terminal value. Any transition that takes longer would be considered abnormal. For the fast filter, 'd' is set to 1 and 'τ_f' (the fast time constant) would then be 1 x 10ms = 10ms. Accordingly, it would take 10ms to attain 63.2% of the filter terminal value. Any transition that takes less time would be considered abnormal. Alternative values for the iteration rate and 'd' for each filter may be chosen according to the circumstances.

Figures 7b and 7c show difference equation block diagrams for further example non-linear recursive filters, specifically a slow rise non-linear recursive filter (i.e., that generates a rise time that is slower than the fall time) and a fast rise non-linear recursive filter (i.e., that generates a rise time that is faster than the fall time) respectively. Implemented generally as described with reference to Figures 3, 6 and 7a, attention is drawn to the respective conditional feedback modules 739.

Combining a slow rise non-linear recursive filter and a fast rise non-linear recursive filter allows acceptance of both positive and negative inputs which represent forward and reverse motor drive, respectively. For the slow rise non-linear recursive filter shown in Figure 7b, and for each iterative calculation, the linear component filter that has the lowest signed value output (least positive or most negative) is chosen as the main filter output.

For the fast rise non-linear recursive filter, and for each iterative calculation, the linear component filter that has the highest signed value output (most positive or least negative) is chosen as the main filter output. The main filter output is used as the feedback for both component filters, the use of a common and conditional feedback rendering the resulting filters non-linear.

Figure 7d shows example filter scaling equation block diagrams 740 for the example non-linear recursive filters shown in Figures 7b and 7c. In an example, these non-linear recursive filters have unity gain and a gain of either 'K_Low' or 'K_High' is applied to the output at each iteration.

Figures 7e-f show data 741 representing the behaviour of the example non-linear recursive filters shown in Figures 7b and 7c. More specifically, the data shown in Figure 7e represents a jam detector internal state response to a stepped input, and the data shown in Figure 7f represents a jam detector internal state response to a ramped input.

The orange line 742 is the motor drive x[n]. The solid blue 743 and solid green lines 744 represent the two non-linear filters, y1uk[n] or the scaled output of the slow rise non-linear recursive filter shown in Figure 7b, and y2uk[n] or the scaled output of the fast rise non-linear recursive filter shown in Figure 7c.

In both data sets the value of 'T' is 0.01 seconds, K_Low = 0.35, K_High = 0.95, '$\tau$1s' = '$\tau$2s' = 0.3, '$\tau$1f' = '$\tau$2f' = 0.05. The dashed red line 745 represents the motor response, with 'K' = 0.5 and '$\tau$'=0.15 in these examples.

The hatched areas 746 represent the zones of jam detection. If the motor back-emf is calculated to be in this zone at any one iterative calculation, a jam/overload flag is set as discussed below.

The above discussion exemplifies the at least one discrete-time recursive filter comprising a non-linear filter comprising first and second component linear filters, each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus 100 is configured to: compare each filter input of the sequence with the filter output of the preceding iteration; and use the second component linear filter when the filter input is lower than the filter output of the preceding iteration, otherwise use the first component linear filter.

Using the second component linear filter when the filter input is lower than the filter output of the preceding iteration, otherwise using the first component linear filter, is the same independent of the sign or polarity of the input.

When the filter input and the filter output are of the same sign, the apparatus may be configured to use the second component linear filter when the magnitude of the filter input is lower than the magnitude of the filter output of the preceding iteration, otherwise use the first component linear filter, and when the filter input and filter output are of the opposite sign, the apparatus may be configured to use the second component linear filter only.

The at least one discrete-time recursive filter comprises a non-linear filter may comprise first and second component linear filters, each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus 100 is configured to: compare the present filter output of the first component linear filter with the present filter output of the second component linear filter; and revise the modelled response using the lower filter output as feedback for both the first and second component linear filters.

The at least one discrete-time recursive filter may comprise a further non-linear filter comprising first and second further component linear filters, each of the first and second further component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus 100 is configured to: compare the present filter output of the first further component linear filter with the present filter output of the second further component linear filter; and revise the modelled response using the higher filter output as feedback for both the first and second further component linear filters.

The apparatus may be configured to select the lower filter output or the higher filter output, as appropriate, to compare with the actual response of the motor.

The apparatus may be configured to: scale each filter output by a scaling factor; determine, from the scaled filter outputs at each iteration of the sequence, the scaled maximum filter output value and the scaled minimum filter output value; and if the drive signal is positive: compare the actual response of the motor to the scaled minimum filter output value, and identify a motor error if the actual response of the motor is less than the scaled minimum filter output value; or if the drive signal is negative: compare the actual response of the motor to the scaled maximum filter output value, and identify a motor error if the actual response of the motor is greater than the scaled maximum filter output value.

Lower may mean a lower magnitude, and higher may mean a higher magnitude.

The time constants may cover a range of expected motor time responses, at maximal resistive load, over an expected set of inertial loading conditions.

The apparatus 100 may be configured to scale the filter output of the at least one discrete-time recursive filter by a scaling factor prior to comparing the modelled response with an actual response of the motor to the drive signal, the scaling factor representing a steady state loading of the motor.

The steady state loading of the motor may be defined as the ratio in steady state of calculated back-EMF to the drive signal, or the ratio of the steady state motor slow down speed to the maximal speed of the motor. The output of each filter may be scaled by the same scaling factor. The scaling factor may lie in the range from 0.01 to 1, preferably in the range from 0.2 to 0.5.

At a conceptual level, the above examples are computations that determine the range of reasonably expected behaviour form a motor. The input to this computation is 'solely' the input to the motor in terms of voltage. As such, this computation in unaware of what the motor is actually doing.

To illustrate further, a motor initially at rest receives a voltage to start rotation. The exact voltage is unknown to the computation since it is dependent on the context of operation (e.g., a user-selected program). The voltage values are, nonetheless, processed as they are input to the computation.

In this example the motor operates form a standing start. Assuming that a 'full' voltage is applied to the motor, if the motor were run with no load it would speed up quickly. If the motor were run with a maximal inertial load, on the other hand, it would speed up slowly. Here, load refers to rotational inertia and not friction.

Assuming further a mass connected to, for example, the blades of a motor, that mass would have an associated rotational mass (the exact relationship dependent on the shape of the mass). Spinning a high rotational mass up to a high rotational speed will take longer than a low rotational mass owing to a larger moment of inertia, particularly when the motor has a restricted (e.g., battery) supply of power. The rise in speed is generally exponential and the time taken is called the mechanical time constant, or the time taken for the motor to spin to approximately 63% of its terminal velocity.

A large mass generally corresponds to a large mechanical time constant while a low mass generally corresponds to a low mechanical time constant. These time constants can be determined by measurements on a specific motor system subject to a range of load conditions. In an example, these time constants may be 1ms for the no-load or fast time mechanical time constant and 20ms for the slow or large mechanical time constant. That is for the no-load situation it would take just 1/1000th of a second to reach ≈ 63% of terminal speed.

Continuing this example further, starting from zero rotational velocity and applying full power, the actual rotational velocity of the motor would be expected to be terminal velocity if read after 1 second. If the actual rotational velocity of the motor is read after 1ms, it may be between virtually zero (for a high mass) and ≈ 63% of terminal velocity (for a low mass).

Crucially, it is not possible to know what the mass is going to be, and so it is necessary to consider the worst-case motor response. The worst-case response is the response that results in the lowest motor RPM. In this particular example, using a single non-linear filter, the worst case is the 20ms time constant, as that is the only quantity (in this scenario) that is relevant, if we wish to use the resultant information for determining whether or not a stall condition exists.

That is, when a motor is speeding up, the higher (e.g., 20ms) time constant is used to determine a motor error, rather than the lower (e.g., 1ms) time constant. This is how the time constants are used in the non-linear filter.

If at a later point in time the motor receives a drive voltage that is less than the originally applied voltage, the computation needs to adapt accordingly in order to produce useful information. For instance, this new voltage could cause the actual motor to start slowing down.

At this later point in time, the computation 'knows' a worst-case value for the modelled motor rotational velocity (but not the actual velocity). If the new drive voltage value is still higher than the equivalent modelled rotational velocity (the filter output voltage before any scaling) then the modelled motor will continue to accelerate. The relevant time constant here is 20ms, so this does not change.

If the new drive voltage value is lower than the modelled rotational velocity (the filter output voltage before any scaling) then the modelled motor will start to decelerate. Without knowledge of the mass load affecting the velocity change, the worst case is taken to mean the lowest absolute velocity, then the worst-case time constant to use here is 1ms. So, the switch between fast and slow time constants is simply dependent on whether or not the filter input is lower or higher than the output (before scaling).

The use of two non-linear filters increases the range of the method to more accurately account for reverse velocities. In this case the second non-linear filter has switched rise and fall times to generate worst case values at negative rotational velocities. This is advantageous when a motor undergoes a reverse velocity start, for example in an anti-jam manoeuvre.

The use of more than two non-linear filters can improve the accuracy of determining the worst-case rotational velocity. The higher the accuracy, the quicker the determination of a jam/overload condition while maintaining a low risk of false errors.

Comparison Data

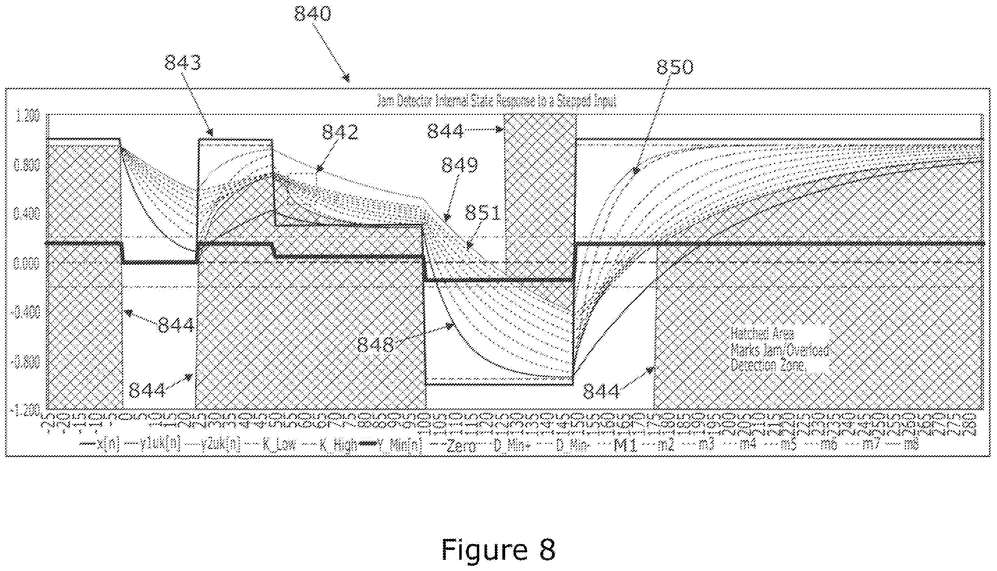

Figure 8 shows comparison data 840 from an example linear filter array 842 and example non-linear filters 848, 849. The example linear filter array 842 comprises eight linear filters; the example non-linear filters 848, 849 are two non-linear filters comprising first and second component linear filters. The non-liner filters are non-liner since their rise times are not the same as their fall times. In this example the rise and fall times of the nonlinear filters are set to the lowest and highest values in the linear filter set.

The orange line 843 is the motor drive x[n] (which goes to zero and is not shown). The solid blue 848 and solid green lines 849 represent the two non-linear filters, y1uk[n] and y2uk[n]. The dotted blue line 850 represents the fastest response linear filter, M1, the dotted green line 851 represents the slowest response linear filter, M8, and the dotted red lines - i.e., the traces between the dotted blue line 850, M1, and the dotted green line 851, M8 - represent all the linear filter responses between.

The hatched areas 844 are the 'stall area', where evasive action is required. This is spaced from the lower envelope of the linear 'filter set' with padding, discussed below.

If the hatched areas 844 were governed by the non-linear filters, they would reside below the solid blue line 848, y1uk[n]. This would result in a hatched area that is significantly smaller to that shown. A smaller hatched area would mean that a jam detection system would be somewhat delayed in determining a jam situation. Were the jam detection system further configured to perform back-to-back anti-jam manoeuvres, the repetition rate would be low as the system would indicate that a jam does not exist for an extended period.

Conversely, with the eight linear filters, the repetition rate for performing back-to-back anti-jam manoeuvres is higher as the jam state is detectable earlier (i.e., the 'stall area' is larger).

The two non-linear filter system performs two filter executions per cycle. The eight linear filter system performs eight filter executions per cycle and so has four times the computational loading.

The two non-linear filter system tends to produce an outcome that is moderately worse than worst case. The eight linear filter system described, tends to produce an outcome that is very slightly better than worst case. As a result, the latter requires 'padding' so there is a gap between the 'stall area' and the inner envelope of the filter set. If this gap were not in place the system could flag a stall when one was not present.

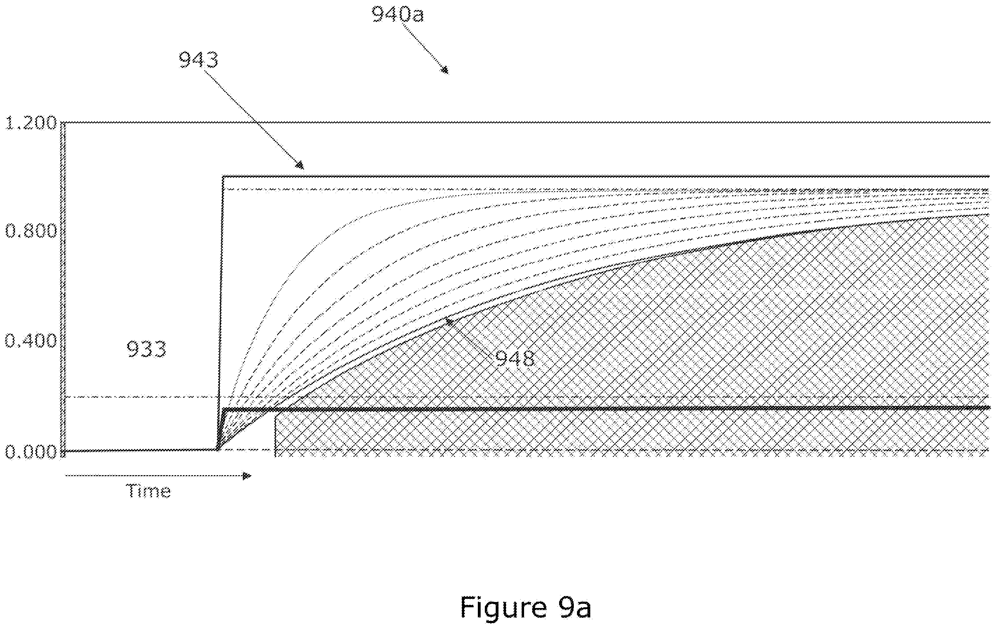

Figure 9a-d shows further comparison data 940a-d for the two systems. The colour coding is the same as for Figure 8, the slowest response is 5x the fastest response, and the time scale is arbitrary.

All filter outputs converge to a value of 0.95 of the motor drive 943, x[n]. The value of 0.95 is the filter gain value which is used here to aid illustration of the data. When friction is properly considered, including heavy loading, this value would be in the region of 0.35, meaning that the motor needs to slow down to at least 35% of its no resistance speed before it can be considered to be in a jam state.

Figure 9a shows simulated data 940a for a step input to maximum from a standing start. For a step input to maximum the two systems are essentially aligned. The dotted blue line (M0, which is under the solid blue line 948, y1uk[n]) and the solid blue line 948, y1uk[n] represent the worst-case motor speed. The worst-case motor speed is taken to be normal behaviour and anything below is not.

When the modelled motor speed is very low the jam detection system is essentially off. This is shown by the truncation of the hatched area 944 to the left. This is preferable, as at low modelled speeds the accuracy of the system is low.

At start up the motor speed is allowed to be slow, and this will not trigger a jam state.

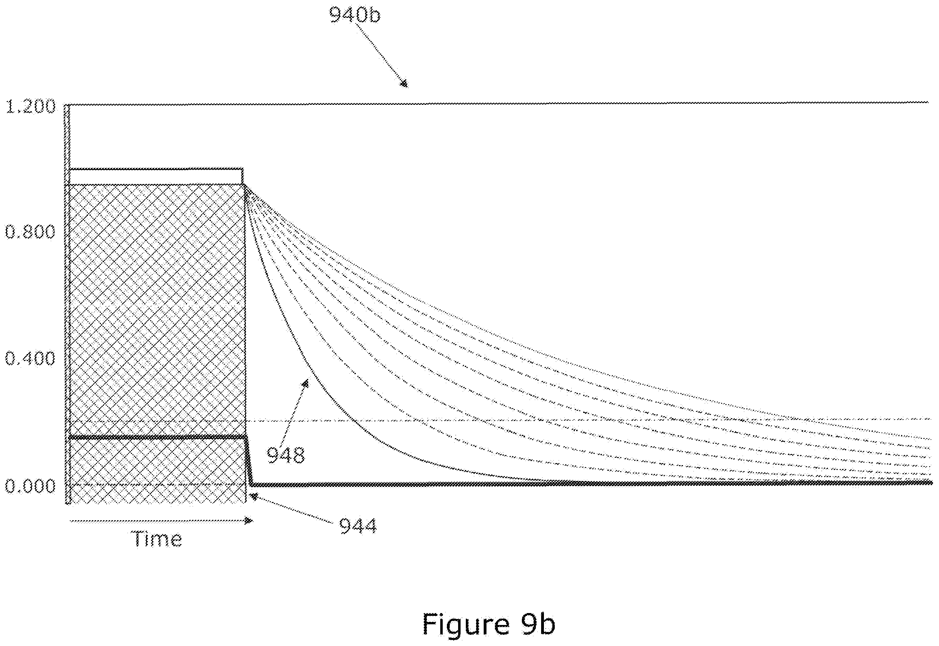

Figure 9b shows simulated data 940b for a step input to zero (thus simulated heavy breaking) from maximum speed. For a step input to zero the two systems are again essentially aligned, but this time dominated by the fast response and not the slow. The hatched area 944 does not appear below the solid blue line 948, yluk[n] as the input is zero. The detection system is switched off when the input is below a pre-determined absolute threshold.

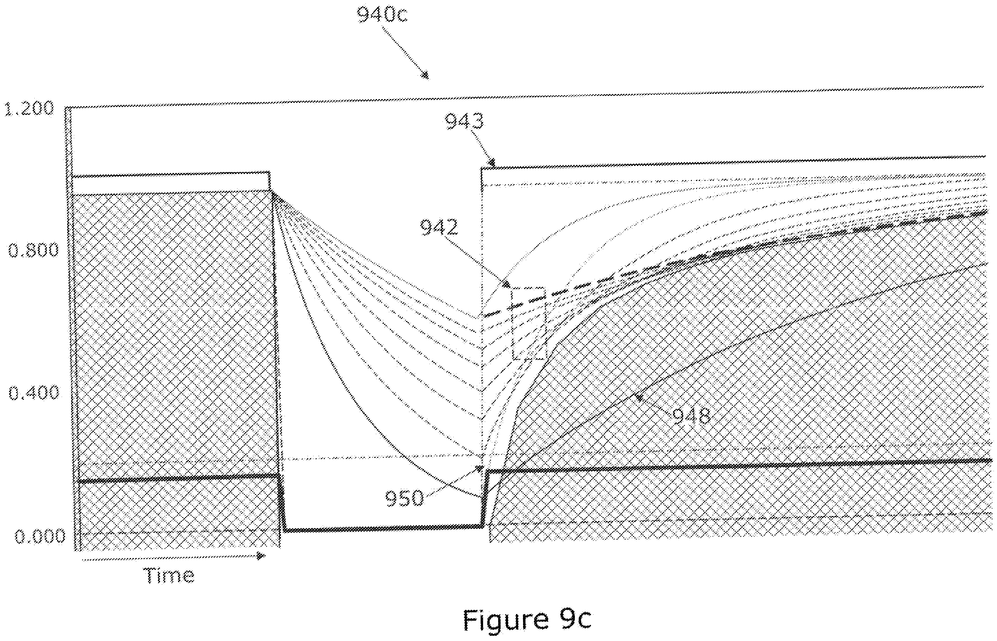

Figure 9c shows simulated data 940c for a momentary step input to zero (thus simulated temporary heavy breaking) from maximum speed. Such a move may be chosen to agitate the contents in a blend program to achieve a more efficient blend. To avoid excessive strain on the system it may be preferable in practice to ramp the drive signal.

In this example the two systems (linear and non-linear) diverge once the power is restored. The non-linear system is overly pessimistic about the motor speed and produces a solid blue line 948, y1uk[n] that is very low. Such a system would potentially 'allow' low speeds and consider these as normal and not flag a jam when one ideally should be.

In the linear system 942, the rapid response 950, M0, dominates when motor drive is restored (this trace has the lowest value). As time progresses the next fastest dominates, followed by the next, then the next, all the way to the slowest response 851, M8.

In essence, the system considers every possible load from zero to the maximum. The lowest value output in the 'set' dominates, as it is the lowest value that is compared with the actual motor speed. Padding can be included in the system to avoid false triggering.

The essential difference between these two systems is that the non-linear system effectively switches the modelled load from low inertial to high inertial as it switches from a fast fall time to a slow rise time. This may not always reflect actual behaviour and could delay jam detection. In contrast, each filter in the linear array does not change its time constant, and so models a load that maintains its inertial property with change in direction. This modelling is closer to reality and so the linear array will produce more representative results. However, non-linear characteristics in the real world, such as a motor's ability to accelerate being significantly different to its ability to decelerate, or dynamically changing load characteristics, could render the linear array overly sensitive in some practical applications.

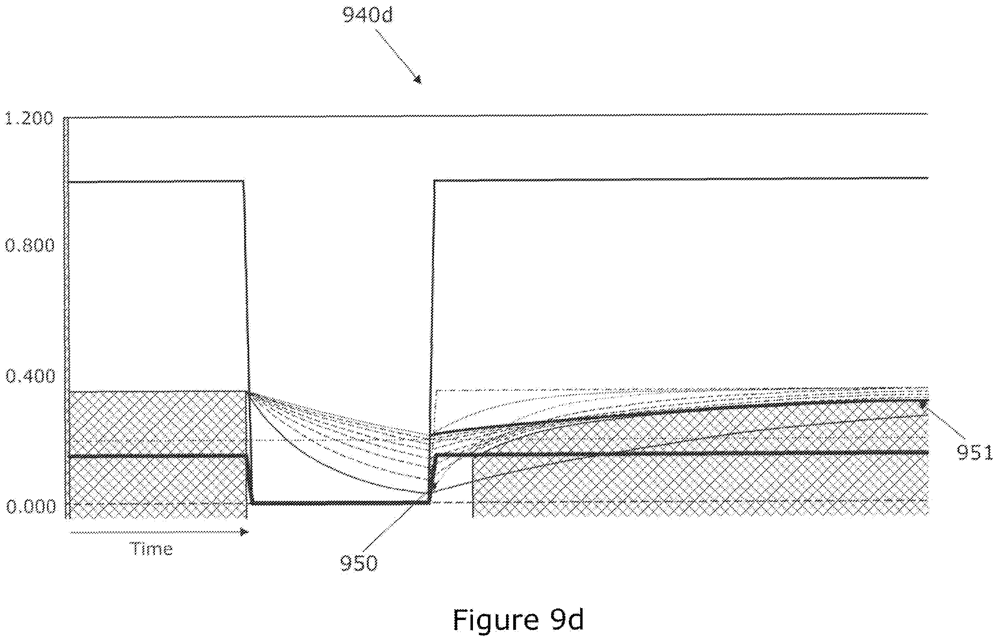

Figure 9d shows simulated data 940d for a momentary step input to zero (thus simulated temporary heavy breaking) from maximum speed with the loading value nearer to 0.35. As such, the data is more reflective of a real system compared to the data shown in Figure 9c.

In certain applications a motor would not be loaded to more than 0.5, which represents a 50% slow down. This is a special point known as the impedance match point. At this point the same amount of power is going into the load as being dissipated in the motor, resulting in a motor efficiency of 50%. Going beyond this point (as an average) is unwanted as the motor will rapidly heat up and operate with low efficiency.

One or more of the following features may apply to any of the examples provided above.

The at least one discrete-time recursive filter may have unity gain. Unity gain may define a filter that has an output equal to its input in steady state conditions.

The motor error may represent a jam or blockage of the motor.

The apparatus 100 may be configured to: compare the drive signal to a first threshold defining a minimum motor drive signal; and compare the modelled response of the motor with the actual response of the motor to identify a motor error only if the drive signal exceeds the magnitude of the first threshold.

The apparatus 100 may be configured to: determine, based on the drive signal, a second threshold defining a minimum modelled motor response to the drive signal; compare the modelled response of the motor with the second threshold; and if the drive signal is positive: compare the modelled response of the motor with the actual response of the motor to identify a motor error if the modelled response is greater than the second threshold; or if the drive signal is negative: compare the modelled response of the motor with the actual response of the motor to identify a motor error if the modelled response is lower than the second threshold.

The apparatus 100 may be configured to: determine, based on the drive signal, a second threshold defining a minimum modelled motor response to the drive signal; compare the modelled response of the motor with the second threshold; and compare the modelled response of the motor with the actual response of the motor to identify a motor error only if the modelled response exceeds the magnitude of the second threshold.

The modelled response of the motor may be compared with the actual response of the motor only: if the drive signal is positive, the minimum output from the one or more filters is above the second threshold, and if the drive signal is negative, the maximum output from the one or more filters is below the second threshold, otherwise, no comparison is made.

The second threshold may be the drive signal scaled by a factor less than 0.5, preferably a factor in the range from 0.05 to 0.2.

The actual response of the motor to the drive signal may comprise a back electromotive force generated by the motor. The apparatus 100 may be configured to: monitor the rotation speed of the motor or the current drawn by the motor; and calculate a back electromotive force based on the monitored rotation speed of the motor or the current drawn by the motor as the actual response of the motor.

The apparatus 100 is one or more of a kitchen appliance, a blender, a portable blender, a mixer, a liquidiser, and a module for one or more of the same. At least one of the motor and the one or more filters may form part of the apparatus 100.

Example Processes and Methods

Once a jam condition is flagged, corrective measures are taken by a jam correction process. Corrective measures take the form of motor manoeuvres designed to remove the jam. These measures may consist of repetitive forward and reverse drive operations that may increase in magnitude over successive cycles.

A jam correction method may comprise: detecting a jam; stopping the motor; applying reverse drive at reduced power for a short period; stopping the motor; applying forward drive at full power; testing for a jam; repeating the method up to N times if the jam exists at high reverse power levels; and, if no jam is detecting, restoring working power to the motor.

A jam correction process may continually monitor the jam detection 'flag' and cease corrective manoeuvres once a jam is signalled not to be present. Once corrective manoeuvres have ceased, the previous operational function is resumed. This would typically be a set of manoeuvres performing a specific function.

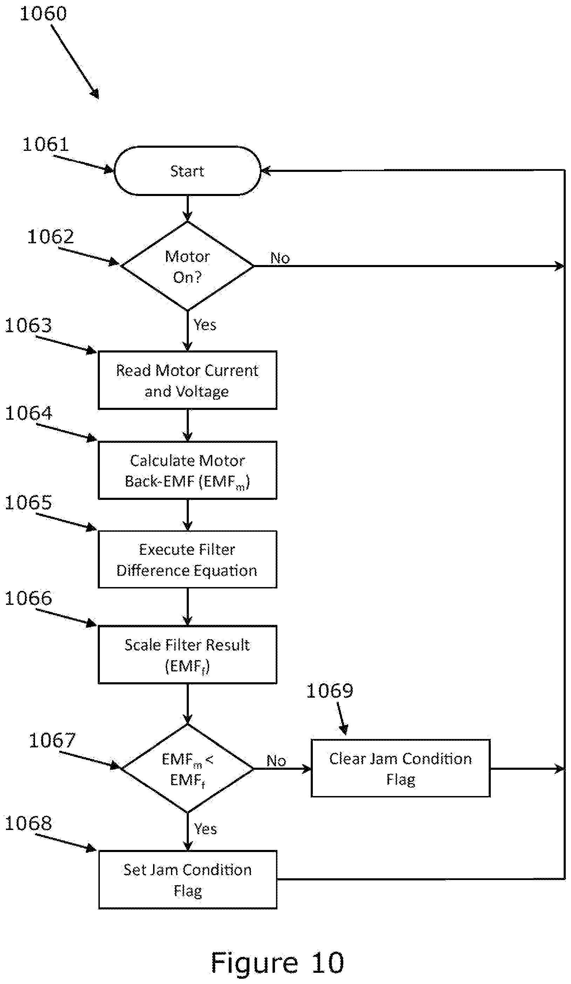

Figure 10 shows a flow diagram for a scheduled jam detection process 1060 according to an example. The steps of the scheduled jam detection process 1060 are: start 1061; check 1062 if the motor is on; if the motor is on, read 1063 the motor current and voltage; calculate 1064 the back-EMF of the motor, $EMF_m$; execute 1065 a filter difference equation; scale 1066 the filter result, $EMF_f$; and determine 1067 whether the calculated back-emf $EMF_m$ is less than the scaled filter result $EMF_f$. If the calculated back-emf $EMF_m$ is less than the scaled filter result $EMF_f$ set 1028 a jam condition flag; otherwise, clear 1069 the jam condition flag. The process repeats after the jam condition flag has been set or cleared. The process also repeats if the 'motor on' check is false.

The filter difference equation is executed every 'T' seconds. The jam condition flag is initially cleared by an initialization routine which is executed at the start of each user program. Here, a user program is a programmed motor control in which each program is selected and initiated by the user.

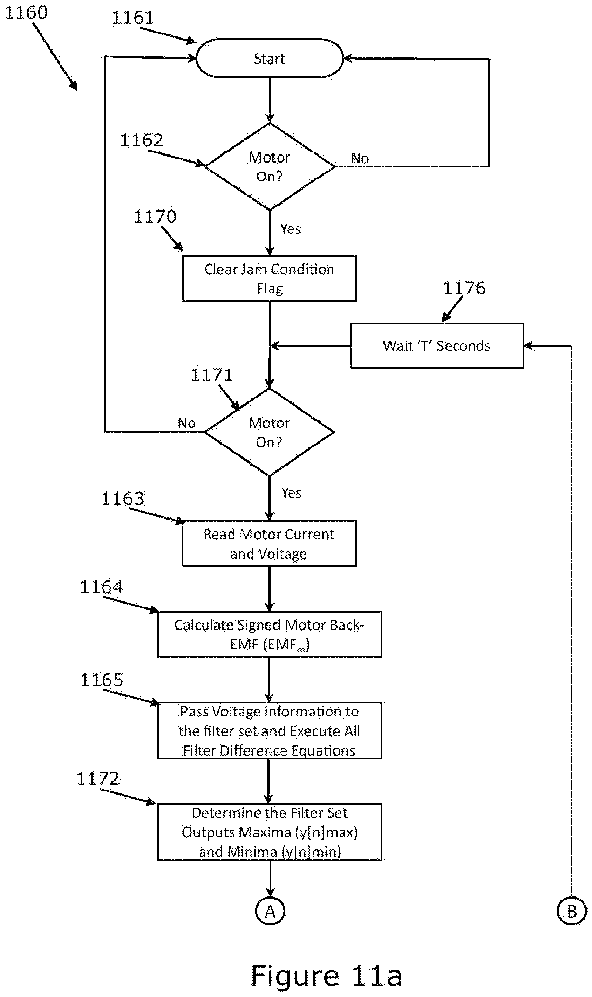

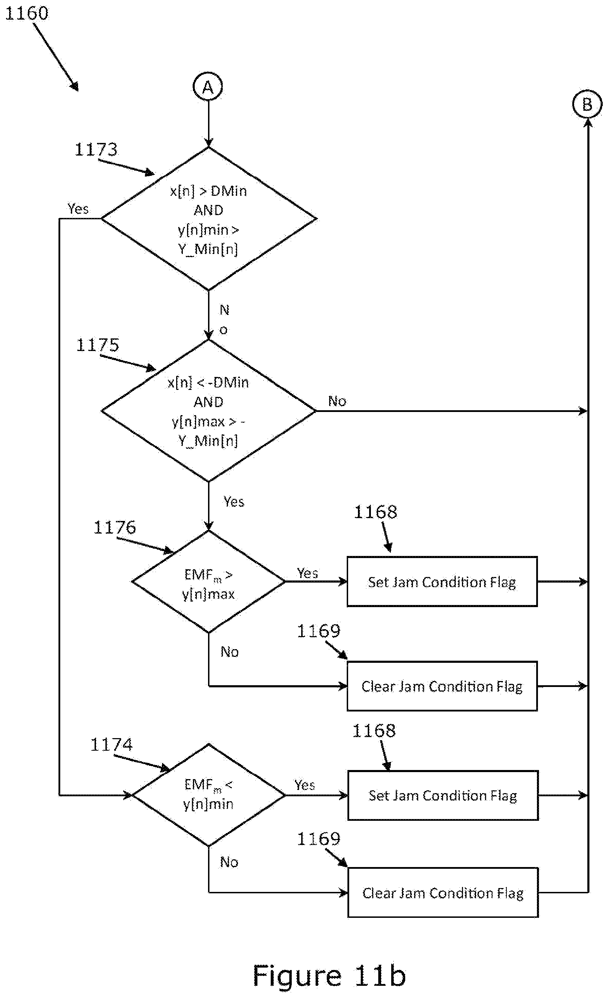

Figures 11a-b show a flow diagram for a scheduled jam detection process 1160 according to another example. The steps of the scheduled jam detection process 1160 are: start 1161; check 1162 if the motor is on; if the motor is on, clear 1170 the jam condition flag; check a second time 1171 if the motor is on; if the motor is on, read 1163 the motor current and voltage; calculate 1164 the back-emf of the motor, $EMF_m$; and pass 1165 voltage information to the filter set and execute all filter difference equations.

The scheduled jam detection process 1160 further comprises determine 1172 the filter set outputs maxima (y[n]max) and minima (y[n]min); and set 1168 a jam condition flag if: x[n] > DMin and y[n]min > Y_Min[n] (step 1173) and $EMF_m$ < y[n]min (step 1174), or if x[n] < -DMin and y[n]max > -Y_Min[n] (step 1175) and $EMF_m$ > y[n]max (step 1176). Otherwise, the process clears 1169 the jam condition flag.

After waiting 1176 for a period 'T', the process repeats after the jam condition flag has been set or cleared. The process also repeats if either 'motor on' check is false.

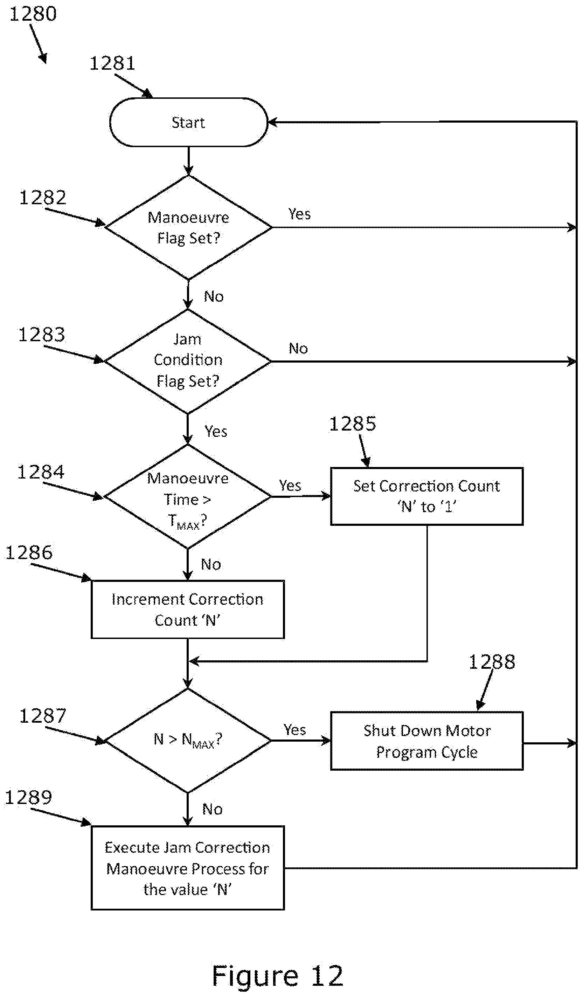

Figure 12 shows a flow diagram for a jam correction control process 1280 according to an example. The steps of the jam correction control process 1280 are: start 1281; check 1282 if the manoeuvre flag has been set; check 1283 if the jam condition flag has been set; determine 1284 whether the manoeuvre time is above a threshold time, $T_{MAX}$; if the manoeuvre time is above the threshold time, $T_{MAX}$, set 1285 a correction count 'N' to '1', otherwise increment 1286 the correction count 'N'; determine 1287 whether the correction count 'N' is above a threshold count, $N_{MAX}$; if the correction count 'N' is above the threshold count, $N_{MAX}$, shut down 1288 the motor program cycle, otherwise execute 1289 the jam correction manoeuvre process for the value 'N'. The flow repeats after the jam correction manoeuvre process for the value 'N' has been executed, and also comprises loops if either the manoeuvre flag is set or the jam condition flag has not been set.

The manoeuvre flag indicates that a set of motor manoeuvres is currently active. The manoeuvre time is the time between the end of the last set of motor manoeuvres and the setting of the jam condition flag. The threshold time, $T_{MAX}$, is the maximum value of manoeuvre time beyond which subsequent manoeuvres are considered new manoeuvres, such that the value of 'N', the correction count, is set to '1'.

The quantity 'N' is the count of the number of attempts to remove a jam. It is always set to '0' at the start of a user selected motor control program. The threshold count, $N_{MAX}$, is the maximum number of correction attempts allowed.

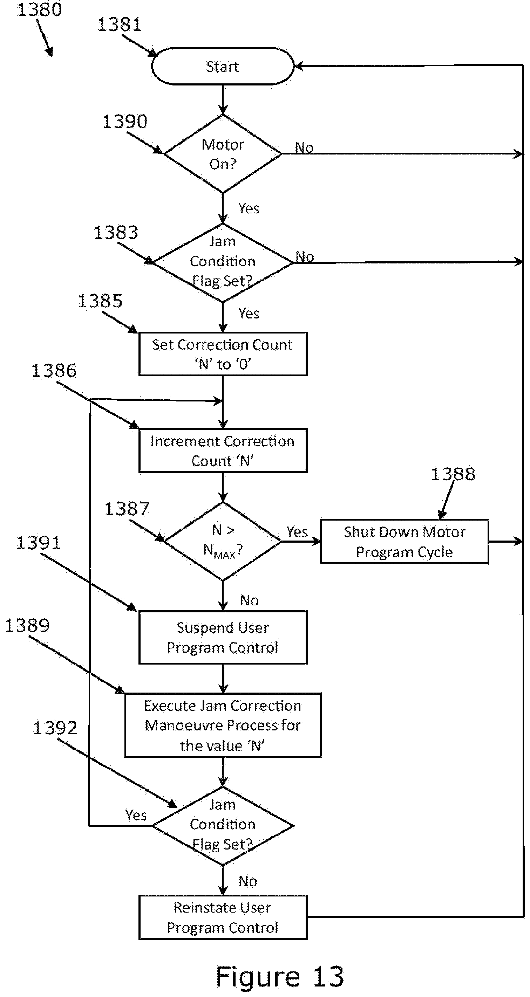

Figure 13 shows a flow diagram for a jam correction control process 1380 according to another example. The steps of the jam correction control process 1380 are: start 1381; check 1390 if the motor is on; check 1383 if the jam condition flag has been set; set 1385 the correction count 'N' to '0'; increment 1386 the correction count 'N'; determine 1387 whether the correction count 'N' is above a threshold count, $N_{MAX}$; if the correction count 'N' is above the threshold count, $N_{MAX}$, shut down 1388 the motor program cycle, otherwise suspend 1391 the user control program; execute 1389 the jam correction manoeuvre process for the value 'N'; and check again 1392 if the jam condition flag has been set. If the jam condition flag remains set, the process repeats at set 1386. Upon motor program cycle shut down, or if the 'motor on' or first 'jam condition flag' checks are false, the process repeats.

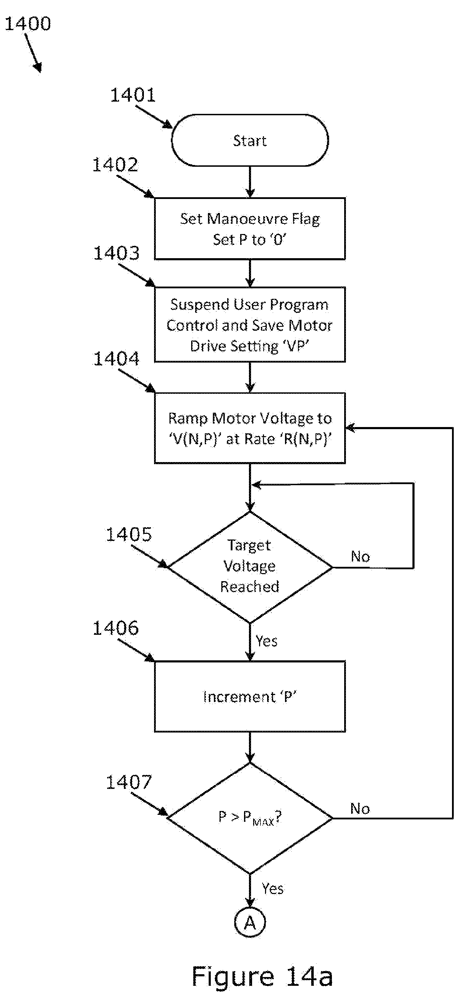

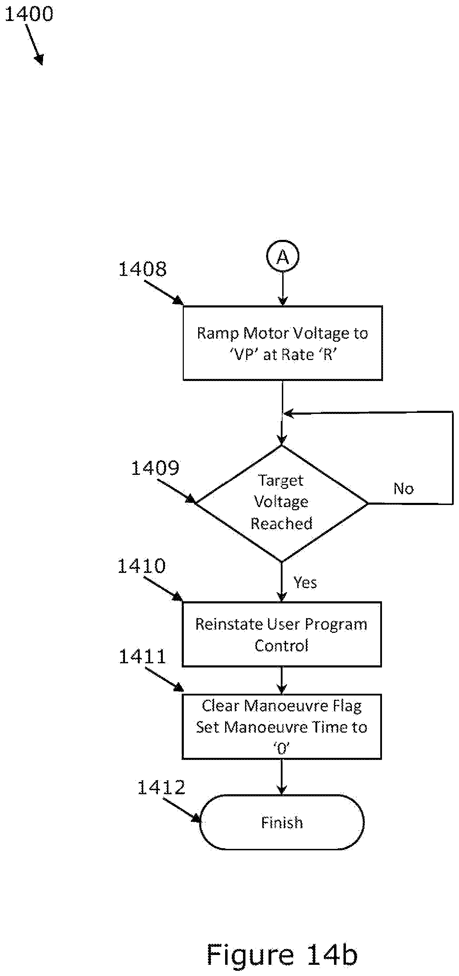

Figures 14a-b show a flow diagram for a jam correction manoeuvre process 1400 according to an example. The steps of the jam correction manoeuvre process 1400 are: start 1401; set 1401 manoeuvre flag and set 'P' to '0'; suspend 1403 user program control and save motor drive settings 'VP'; ramp 1404 motor voltage to 'V(N, P)' at rate 'R(N, P)'; check 1405 whether the target voltage has been reached; if the target voltage has been reached, increment 1406 the manoeuvre flag 'P'; determine 1407 whether the manoeuvre flag 'P' is greater than a maximum manoeuvre flag '$P_{MAX}$'; if the manoeuvre flag 'P' is greater than a maximum manoeuvre flag '$P_{MAX}$', ramp 1408 the motor voltage to 'VP' at rate 'R'; determine 1409 whether the target voltage has been reached; if the target voltage has been reached, reinstate 1410 user program control; clear 1411 manoeuvre flag and set manoeuvre time to '0'; and finish 1412. The process repeats if either the first target voltage check is false or if $P < P_{Max}$.

The quantity 'N' is the manoeuvre sequence number or count of the number of attempts to remove a jam. Each values represents a 'set' of manoeuvres. The maximum value (i.e., the acceptable number of correction attempts) is $N_{MAX}$. The quantity 'P' is the manoeuvre number. Each value represents a particular drive voltage and ramp rate to the motor. The maximum value is $P_{MAX}$ and may be chosen from the range of 2 to 4.

The quantity 'VP' is the drive voltage to the motor at the point the anti-jam manoeuvres commence. This value is reinstated at the end of the manoeuvre sequence. The quantity V(N,P) is a 2-dimensional array of values of size N x P. Each values represents a motor drive voltage for use in the manoeuvre sequences. For each set 'N', the values are independently set.

The quantity R(N,P) is a 2-dimensional array of values of size N x P. Each value represents a motor drive voltage ramp rate for use in the manoeuvre sequences. Each value has units of voltage per unit time. For each set 'N', the values are independently set.

The quantity 'Target Voltage Reached' is a Boolean (yes/no) check that indicates if the drive process has reached its target voltage. The quantity 'R' is a predetermined voltage ramp rate for use in returning the voltage drive to the motor to its original value, that is just before the anti-jam manoeuvres began.

'User Program' refers to a pre-selected and functional set of manoeuvres, chosen by the user to perform a specific task.

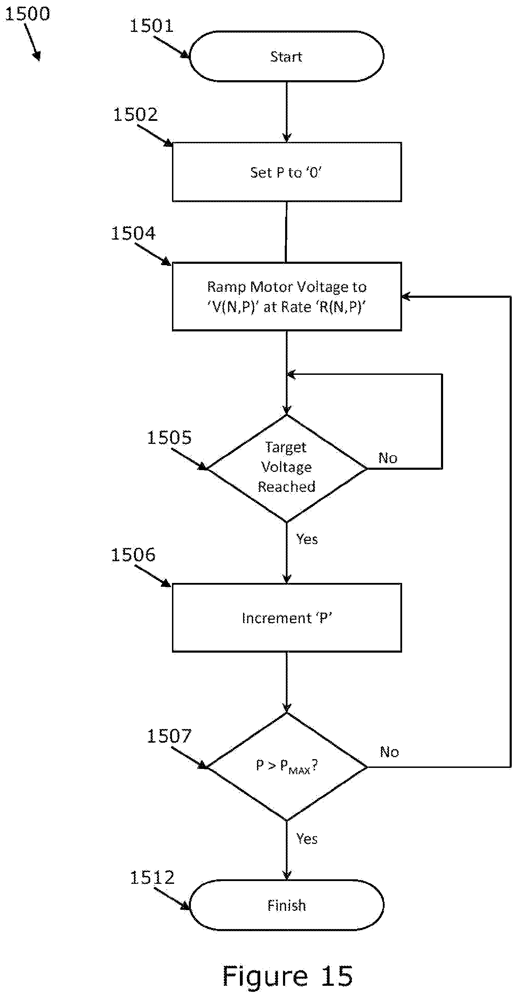

Figure 15 shows a flow diagram for a jam correction manoeuvre process 1500 according to another example. The steps of the jam correction manoeuvre process 1500 are: start 1501; set 1502 'P' to '0'; ramp 1504 motor voltage to 'V(N, P)' at rate 'R(N, P)'; check 1505 whether the target voltage has been reached; if the target voltage has been reached, increment 1506 'P'; determine 1507 whether the manoeuvre flag 'P' is greater than a maximum manoeuvre flag '$P_{MAX}$'; if the manoeuvre flag 'P' is greater than a maximum manoeuvre flag '$P_{MAX}$', finish 1512. The process repeats if the target voltage check is false or if $P < P_{Max}$.

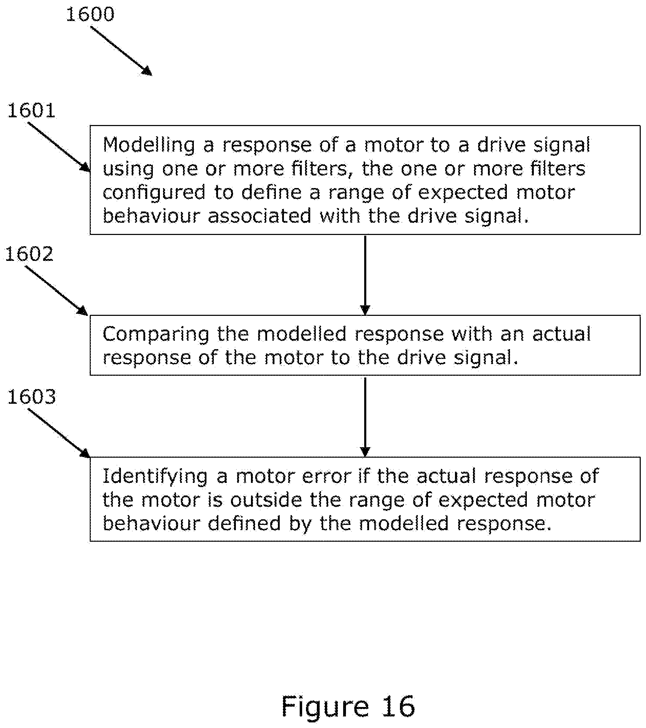

Figure 16 shows a flow diagram of a method 1600 of identifying a motor error, which may be implemented according to the scheduled jam detection processes described above. The method 1600 comprises modelling 1601 a response of a motor to a drive signal using one or more filters, the one or more filters configured to define a range of expected motor behaviour associated with the drive signal; comparing 1602 the modelled response with an actual response of the motor to the drive signal; and identifying 1603 a motor error if the actual response of the motor is outside the range of expected motor behaviour defined by the modelled response.

The method may be repeated at an iteration rate, wherein the iteration rate lies in the range from 100Hz to 1kHz, preferably from 100Hz to 500Hz.

The jam correction control processes and jam correction manoeuvre process exemplify the apparatus 100, on identification of a motor error, being configured to execute a correction procedure, the correction procedure comprising: adjusting the drive signal; modelling a response of the motor to the adjusted drive signal; comparing the modelled response with an actual response of the motor to the adjusted drive signal; and determining that the motor error has been corrected if the actual response of the motor is within the range of expected motor behaviour defined by the modelled response, otherwise repeating the correction procedure.

The correction procedure may further comprise suspending a user program for the motor before adjusting the drive signal; and reinstating the user program for the motor upon determining that the motor error has been corrected.

The apparatus 100 may be configured to provide an indication of a motor error timeout if the actual response of the motor is outside the range of expected motor behaviour after a predefined time or number of drive signal adjustments.

The apparatus 100 may be configured to adjust one or more of the magnitude, rate of change and polarity of the drive signal with each iteration of drive signal adjustment.

**Claims**

1. An apparatus (100) comprising:

   at least one processor (102); and
   at least one memory (104) including computer program code,
   the at least one memory (104) and the computer program code configured to, with the at least one processor, cause the apparatus to:

   model a response of a motor (220) to a drive signal (443) using one or more filters (212a, 212b, 330, 552, 630, 730), the one or more filters configured to define a range of expected motor behaviour (441, 442) associated with the drive signal;
   compare the modelled response with an actual response of the motor to the drive signal; and
   identify a motor error if the actual response of the motor is outside the range of expected motor behaviour (444) defined by the modelled response,
   wherein, on identification of a motor error, the apparatus is configured to execute a correction procedure (1280), the correction procedure comprising:

   adjusting the drive signal;

   modelling a response of the motor to the adjusted drive signal;
   comparing the modelled response with an actual response of the motor to the adjusted drive signal; and
   determining that the motor error has been corrected if the actual response of the motor is within the range of expected motor behaviour defined by the modelled response, otherwise repeating the correction procedure, and
   wherein the apparatus is one or more of a kitchen appliance, a blender, a portable blender, a mixer, a liquidiser, and a module for one or more of the same.

2. The apparatus (100) of claim 1, wherein the one or more filters comprise at least one discrete-time recursive filter configured to receive a sequence of filter inputs indicative of drive signals forming part of a drive operation, and generate a plurality of respective filter outputs defining the associated modelled response of the motor, and wherein the apparatus is configured to iteratively revise the modelled response with each filter input of the sequence, using the filter output of the preceding iteration as feedback.

3. The apparatus (100) of claim 2, wherein the at least one discrete-time recursive filter comprises a plurality of linear filters each having a respective time constant for use in revising the modelled response, the respective time constants defining the time taken by the motor to reach a predefined percentage of terminal speed under different load conditions for expected motor behaviour.

4. The apparatus (100) of claim 2, wherein the at least one discrete-time recursive filter comprises a non-linear filter having longer and shorter time constants for use in revising the modelled response, the longer and shorter time constants defining the time taken by the motor to reach a predefined percentage of terminal speed under a range of load conditions for expected motor behaviour, and wherein the apparatus is configured to:

   compare each filter input of the sequence with the filter output of the preceding iteration; and
   when the filter input and the filter output are of the same sign, switch from the longer time constant to the shorter time constant when the magnitude of the filter input is lower than the magnitude of the filter output of the preceding iteration, otherwise use the longer time constant, and when the filter input and filter output are of the opposite sign, use the shorter time constant only.

**5.** The apparatus (100) of claim 2, wherein the at least one discrete-time recursive filter comprises a non-linear filter (330) having rise and fall time constants for use in revising the modelled response, the rise and fall time constants defining the time taken by the motor to accelerate and decelerate to respective predefined percentages of terminal speed under a predefined load condition for expected motor behaviour, and wherein the apparatus is configured to:

> compare each filter input of the sequence with the filter output of the preceding iteration; and when the filter input and filter output are of the same sign, switch from the rise time constant to the fall time constant when the magnitude of the filter input is lower than the magnitude of the filter output of the preceding iteration, otherwise use the rise time constant; and when the filter input and the filter output are of the opposite sign, use the fall time constant only.

**6.** The apparatus (100) of claim 5, wherein the at least one discrete-time recursive filter comprises a plurality of non-linear filters, each non-linear filter having associated rise and fall time constants for use in revising the modelled response, the associated rise and fall time constants defining the time taken by the motor to accelerate and decelerate to respective predefined percentages of terminal speed under a predefined load condition for expected motor behaviour, and wherein the apparatus is configured to:

> scale each filter output by a scaling factor; determine, from the scaled filter outputs of the plurality of non-linear filters at each iteration of the sequence, the scaled maximum filter output value and the scaled minimum filter output value; and
> if the drive signal is positive:
>
>> compare the actual response of the motor to the scaled minimum filter output value, and identify a motor error if the actual response of the motor is less than the scaled minimum filter output value; or
>
> if the drive signal is negative:
>
>> compare the actual response of the motor to the scaled maximum filter output value, and identify a motor error if the actual response of the motor is greater than the scaled maximum filter output value.

**7.** The apparatus (100) of claim 6, wherein:

> the plurality of non-linear filters comprises a first set and a second set, the ratio of each rise time constant to its corresponding fall time constant in the first set is equal to a first asymmetry factor, and the ratio of each rise time constant to its corresponding fall time constant in the second set is equal to a second asymmetry factor which is less than the first asymmetry factor, optionally wherein the first set and the second set each comprise from 4 to 8 non-linear filters; or
> the ratio of each rise time constant to its corresponding fall time constant is equal to an asymmetry factor.

**8.** The apparatus (100) of claim 2, wherein the at least one discrete-time recursive filter comprises a non-linear filter comprising first and second component linear filters, each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to:

> compare each filter input of the sequence with the filter output of the preceding iteration; and use the second component linear filter when the filter input is lower than the filter output of the preceding iteration, otherwise use the first component linear filter.

**9.** The apparatus (100) of claim 2, wherein the at least one discrete-time recursive filter (730) comprises a non-linear filter comprising first and second component linear filters (730a, 730b), each of the first and second component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to:

> compare (739) the present filter output of the first component linear filter with the present filter output of the second component linear filter; and revise the modelled response using the lower filter output as feedback for both the first and second component linear filters
> optionally, wherein the at least one discrete-time recursive filter comprises a further non-linear filter comprising first and second further component linear filters, each of the first and second further component linear filters having a respective time constant for use in revising the modelled response, the time constants defining the time taken by the motor to reach a predefined percentage of terminal speed, from the longest to the shortest, under all anticipated motor load conditions, respectively, and wherein the apparatus is configured to:

compare the present filter output of the first further component linear filter with the present filter output of the second further component linear filter; and
revise the modelled response using the higher filter output as feedback for both the first and second further component linear filters.

10. The apparatus (100) of any of claims 2 to 5 and 8 to 9, wherein the apparatus is configured to scale the filter output of the at least one discrete-time recursive filter by a scaling factor (554) prior to comparing the modelled response with an actual response of the motor to the drive signal, the scaling factor representing a steady state loading of the motor.

11. The apparatus (100) of any preceding claim, wherein the apparatus is configured to:

compare the drive signal to a first threshold (446, 447) defining a minimum motor drive signal; and
compare the modelled response of the motor with the actual response of the motor to identify a motor error only if the drive signal exceeds the magnitude of the first threshold, and/or wherein the apparatus is configured to:

determine, based on the drive signal, a second threshold (445) defining a minimum modelled motor response to the drive signal;
compare the modelled response of the motor with the second threshold; and
if the drive signal is positive:

compare the modelled response of the motor with the actual response of the motor to identify a motor error if the modelled response is greater than the second threshold; or
if the drive signal is negative:
compare the modelled response of the motor with the actual response of the motor to identify a motor error if the modelled response is lower than the second threshold.

12. The apparatus (100) of claim 1, wherein the apparatus is configured to provide an indication of a motor error timeout if the actual response of the motor is outside the range of expected motor behaviour after a predefined time or number of drive signal adjustments.

13. The apparatus (100) of claim 12, wherein the apparatus is configured to adjust one or more of the magnitude, rate of change and polarity of the drive signal with each iteration of drive signal adjustment.

14. A method (1600) performed by the apparatus (100) of claim 1, the method comprising:

modelling (1601) a response of a motor (220) to a drive signal using one or more filters, the one or more filters configured to define a range of expected motor behaviour associated with the drive signal;
comparing (1602) the modelled response with an actual response of the motor to the drive signal; and
identifying (1603) a motor error if the actual response of the motor is outside the range of expected motor behaviour defined by the modelled response,
wherein, on identification of a motor error, the method comprises executing a correction procedure (1280), the correction procedure comprising:

adjusting the drive signal;
modelling a response of the motor to the adjusted drive signal;
comparing the modelled response with an actual response of the motor to the adjusted drive signal; and
determining that the motor error has been corrected if the actual response of the motor is within the range of expected motor behaviour defined by the modelled response, otherwise repeating the correction procedure.

15. A computer program comprising computer code to cause the apparatus of claim 1 to perform the method of claim 14.

**Patentansprüche**

1. Einrichtung (100), umfassend:

mindestens einen Prozessor (102); und
einen Speicher (104), einschließend einen Computerprogrammcode,
mindestens einen Speicher (104) und den Computerprogrammcode, der so konfiguriert ist, dass er zusammen mit mindestens einem Prozessor die Einrichtung dazu veranlasst:

eine Reaktion eines Motors (220) auf ein Antriebssignal (443) unter Verwendung eines oder mehrerer Filter (212a, 212b, 330, 552, 630, 730) zu modellieren, wobei der eine oder die mehreren Filter so konfiguriert sind, dass sie einen Bereich des erwarteten Motorverhaltens (441, 442) definieren, der mit dem Antriebssignal verbunden ist;
die modellierte Reaktion mit einer tatsächlichen Reaktion des Motors auf das Antriebssignal zu vergleichen; und
einen Motorfehler zu identifizieren, wenn die tatsächliche Reaktion des Motors außerhalb des Bereichs des erwarteten Motorverhaltens (444) liegt, das durch die modellierte Reaktion definiert ist,
wobei die Einrichtung beim Identifizieren eines Motorfehlers so konfiguriert ist, dass sie ein Korrekturverfahren (1280) ausführt, der Korrekturvorgang umfassend:

Anpassen des Antriebssignals;
Modellieren einer Reaktion des Motors auf das angepasste Antriebssignal;
Vergleichen der modellierten Reaktion mit der tatsächlichen Reaktion des Motors auf das angepasste Antriebssignal; und
Bestimmen, dass der Motorfehler korrigiert wurde, wenn die tatsächliche Reaktion des Motors innerhalb des Bereichs des erwarteten Motorverhaltens liegt, das durch die modellierte Reaktion definiert ist, andernfalls das Wiederholen des Korrekturvorgangs, und wobei es sich bei der Einrichtung um eine oder mehrere Kücheneinrichtungen, einen Mixer, einen tragbaren Mixer, einen Rührgerät, einen Zerkleinerer und ein Modul für eine oder mehrere dieser Einrichtungen handelt.

2. Einrichtung (100) nach Anspruch 1, wobei der eine oder die mehreren Filter mindestens einen zeitdiskreten rekursiven Filter umfassen, der so konfiguriert ist, dass er eine Sequenz von Filtereingängen empfängt, die Antriebssignale anzeigen, die Teil eines Antriebsvorgangs sind, und eine Vielzahl von entsprechenden Filterausgängen erzeugt, die die damit verbundene modellierte Reaktion des Motors definieren, und wobei die Einrichtung so konfiguriert ist, dass sie die modellierte Reaktion mit jedem Filtereingang der Sequenz iterativ überarbeitet, wobei der Filterausgang der vorstehenden Iteration als Rückkopplung verwendet wird.

3. Einrichtung (100) nach Anspruch 2, wobei der mindestens eine zeitdiskrete rekursive Filter eine Vielzahl von linearen Filtern umfasst, die jeweils eine entsprechende Zeitkonstante verwenden, um die modellierte Reaktion zu überarbeiten, wobei die entsprechenden Zeitkonstanten die Zeit definieren, die der Motor benötigt, um unter verschiedenen Lastbedingungen einen vordefinierten Prozentsatz der Enddrehzahl für das erwartete Motorverhalten zu erreichen.

4. Einrichtung (100) nach Anspruch 2, wobei der mindestens eine zeitdiskrete rekursive Filter einen nichtlinearen Filter mit längeren und kürzeren Zeitkonstanten verwendet, um die modellierte Reaktion zu überarbeiten, wobei die längeren und kürzeren Zeitkonstanten die Zeit definieren, die der Motor benötigt, um einen vordefinierten Prozentsatz der Enddrehzahl unter einer Reihe von Lastbedingungen für das erwartete Motorverhalten zu erreichen, und wobei die Einrichtung so konfiguriert ist, dass sie:

jeden Filtereingang der Sequenz mit dem Filterausgang der vorstehenden Iteration vergleicht; und
wenn der Filtereingang und der Filterausgang das gleiche Vorzeichen haben, von der längeren Zeitkonstante zur kürzeren Zeitkonstante wechselt, wenn die Größe des Filtereingangs niedriger ist als die Größe des Filterausgangs der vorstehenden Iteration, andernfalls die längere Zeitkonstante verwendet, und wenn der Filtereingang und der Filterausgang das entgegengesetzte Vorzeichen haben, nur die kürzere Zeitkonstante verwendet.

5. Einrichtung (100) nach Anspruch 2, wobei der mindestens eine zeitdiskrete rekursive Filter einen nichtlinearen Filter (330) mit Anstiegs- und Abfallzeitkonstanten verwendet, um die modellierte Reaktion zu überarbeiten, wobei die Anstiegs- und Abfallzeitkonstanten die Zeit definieren, die der Motor benötigt, um unter einer vordefinierten Lastbedingung für das erwartete Motorverhalten auf jeweilige vordefinierte Prozentsätze der Enddrehzahl zu beschleunigen und abzubremsen, und wobei die Einrichtung so konfiguriert ist, dass sie:

jeden Filtereingang der Sequenz mit dem Filterausgang der vorstehenden Iteration vergleicht; und
wenn der Filtereingang und der Filterausgang das gleiche Vorzeichen haben, von der Anstiegszeitkonstante zur Abfallzeitkonstante wechselt, wenn die Größe des Filtereingangs niedriger ist als die Größe des Filterausgangs der vorstehenden Iteration, andernfalls die Anstiegszeitkonstante verwendet; und wenn der Filtereingang und der Filterausgang das entgegengesetzte Vorzeichen haben, nur die Abfallzeitkonstante verwendet.

6. Einrichtung (100) nach Anspruch 5, wobei der mindestens eine zeitdiskrete rekursive Filter eine Vielzahl von nichtlinearen Filtern umfasst, wobei jeder nichtlineare Filter damit verbundene Anstiegs- und Abfallzeitkonstanten verwendet, um sie bei der Überarbeitung der modellierten Reaktion zu verwenden, wobei die damit verbundenen Anstiegs- und Abfallzeitkonstanten die Zeit definieren, die der Motor benötigt, um unter einer vordefinierten Lastbedingung auf einen vordefinierten Prozentsatz der Enddrehzahl zu beschleunigen und abzubremsen, um das erwartete Motorverhalten zu erzielen, und wobei die Einrichtung so konfiguriert ist, dass sie:

jeden Filterausgang um einen Skalierungsfaktor skaliert;
aus den skalierten Filterausgangssignalen der Vielzahl nichtlinearer Filter bei jeder Iteration der Sequenz den skalierten maximalen Filterausgangssignalwert und den skalierten minimalen Filterausgangssignalwert bestimmt; und
wenn das Antriebssignal positiv ist:

die tatsächliche Reaktion des Motors mit dem skalierten minimalen Filterausgangswert vergleicht und
einen Motorfehler identifizieren, wenn die tatsächliche Reaktion des Motors kleiner ist als der skalierte minimale Filterausgangswert; oder
wenn das Antriebssignal negativ ist:

die tatsächliche Reaktion des Motors mit dem skalierten maximalen Filterausgangswert vergleichen und
einen Motorfehler identifizieren, wenn die tatsächliche Reaktion des Motors größer ist als der skalierte maximale Filterausgangswert.

7. Einrichtung (100) nach Anspruch 6, wobei:

die Vielzahl nichtlinearer Filter einen ersten Satz und einen zweiten Satz umfasst, das Verhältnis jeder Anstiegszeitkonstante zu ihrer entsprechenden Abfallzeitkonstante im ersten Satz gleich einem ersten Asymmetriefaktor ist und das Verhältnis jeder Anstiegszeitkonstante zu ihrer entsprechenden Abfallzeitkonstante im zweiten Satz gleich einem zweiten Asymmetriefaktor ist, der kleiner als der erste Asymmetriefaktor ist, wobei optional der erste Satz und der zweite Satz jeweils 4 bis 8 nichtlineare Filter umfassen; oder
das Verhältnis jeder Anstiegszeitkonstante zu ihrer entsprechenden Abfallzeitkonstante einem Asymmetriefaktor entspricht.

8. Einrichtung (100) nach Anspruch 2, wobei der mindestens eine zeitdiskrete rekursive Filter einen nichtlinearen Filter umfasst, umfassend einen ersten und einen zweiten linearen Komponentenfilter, wobei jeder der ersten und zweiten linearen Komponentenfilter eine jeweilige Zeitkonstante verwendet, um die modellierte Reaktion zu überarbeiten, wobei die Zeitkonstanten die Zeit definieren, die der Motor benötigt, um einen vordefinierten Prozentsatz der Enddrehzahl zu erreichen, von der längsten bis zur kürzesten, unter allen zu erwartenden Motorlastbedingungen, und wobei die Einrichtung so konfiguriert ist, dass sie:

jeden Filtereingang der Sequenz mit dem Filterausgang der vorstehenden Iteration vergleicht; und
den zweiten linearen Komponentenfilter verwendet, wenn der Filtereingang niedriger ist als der Filterausgang der vorstehenden Iteration, andernfalls den ersten linearen Komponentenfilter verwendet.

9. Einrichtung (100) nach Anspruch 2, wobei der mindestens eine zeitdiskrete rekursive Filter (730) einen nichtlinearen Filter umfasst, umfassend einen ersten und einen zweiten linearen Komponentenfilter (730a, 730b), wobei jeder der ersten und zweiten linearen Komponentenfilter eine jeweilige Zeitkonstante verwendet, um die modellierte Reaktion zu überarbeiten, wobei die Zeitkonstanten die Zeit definieren, die der Motor benötigt, um einen vordefinierten Prozentsatz der Enddrehzahl zu erreichen, von der längsten bis zur kürzesten, unter allen erwarteten Motorlastbedingungen, und wobei die Einrichtung so konfiguriert ist, dass sie:

den aktuellen Filterausgang des ersten linearen Komponentenfilters mit dem aktuellen Filterausgang des zweiten linearen Komponentenfilters vergleicht (739); und
die modellierte Reaktion unter Verwendung des unteren Filterausgangs als Rückkopplung sowohl für das erste als auch für den zweiten linearen Komponentenfilter überarbeitet.
optional, wobei der mindestens eine zeitdiskrete rekursive Filter einen weiteren nichtlinearen Filter umfasst, umfassend einen ersten und einen zweiten weiteren linearen Komponentenfilter, wobei jeder der ersten und zweiten weiteren linearen Komponentenfilter eine jeweilige Zeitkonstante verwendet, um die modellierte Reaktion zu überarbeiten, wobei die Zeitkonstanten die Zeit definieren, die der Motor benötigt, um einen vordefinierten Prozentsatz der Enddrehzahl zu erreichen, von der längsten bis zur kürzesten, unter allen zu erwartenden Motorlastbedingungen, und wobei die Einrichtung so konfiguriert ist, dass sie:

den aktuellen Filterausgang des ersten linearen weiteren Komponentenfilters mit dem aktuellen Filterausgang des zweiten weiteren linearen Komponentenfilters vergleicht; und
die modellierte Reaktion unter Verwendung des höheren Filterausgangs als Rückkopplung sowohl für das erste als auch für den zweiten weiteren linearen Komponentenfilter überarbeitet.

10. Einrichtung (100) nach einem der Ansprüche 2 bis 5 und 8 bis 9, wobei die Einrichtung so konfiguriert ist, dass sie den Filterausgang des mindestens einen zeitdiskreten rekursiven Filters vor dem Vergleich der modellierten Reaktion mit einer tatsächlichen Reaktion des Motors auf das Antriebssignal um einen Skalierungsfaktor (554) skaliert, wobei der Skalierungsfaktor eine stationäre Belastung des Motors darstellt.

11. Einrichtung (100) nach einem der vorstehenden Ansprüche, wobei die Einrichtung so konfiguriert ist, dass sie:

   das Antriebssignal mit einem ersten Schwellenwert (446, 447) vergleicht, der ein minimales Motorantriebssignal definiert; und
   die modellierte Reaktion des Motors mit der tatsächlichen Reaktion des Motors vergleicht, um einen Motorfehler nur dann zu identifizieren, wenn das Antriebssignal den Wert des ersten Schwellenwerts überschreitet, und/oder
   wobei die Einrichtung so konfiguriert ist, dass sie:

      basierend auf dem Antriebssignal einen zweiten Schwellenwert (445) bestimmt, der eine minimale modellierte Motorreaktion auf das Antriebssignal definiert;
      die modellierte Reaktion des Motors mit dem zweiten Schwellenwert vergleicht; und
      wenn das Antriebssignal positiv ist:

         die modellierte Reaktion des Motors mit der tatsächlichen Reaktion des Motors vergleicht, um einen Motorfehler zu identifizieren, wenn die modellierte Reaktion größer als der zweite Schwellenwert ist; oder
         wenn das Antriebssignal negativ ist:
         die modellierte Reaktion des Motors mit der tatsächlichen Reaktion des Motors vergleicht, um einen Motorfehler zu identifizieren, wenn die modellierte Reaktion niedriger als der zweite Schwellenwert ist.

12. Einrichtung (100) nach Anspruch 1, wobei die Einrichtung so konfiguriert ist, dass sie eine Anzeige eines Zeitüberschreitungsfehlers des Motors bereitstellt, wenn die tatsächliche Reaktion des Motors nach einer vordefinierten Zeit oder Anzahl von Antriebssignalanpassungen außerhalb des Bereichs des erwarteten Motorverhaltens liegt.

13. Einrichtung (100) nach Anspruch 12, wobei die Einrichtung so konfiguriert ist, dass sie bei jeder Iteration der Antriebssignalanpassung eine oder mehrere der Größen, Änderungsraten und Polaritäten des Antriebssignals anpasst.

14. Verfahren (1600), das von der Einrichtung (100) nach Anspruch 1 durchgeführt wird, das Verfahren umfassend:

   Modellieren (1601) einer Reaktion eines Motors (220) auf ein Antriebssignal unter Verwendung eines oder mehrerer Filter, wobei der eine oder die mehreren Filter so konfiguriert sind, dass sie einen Bereich des erwarteten Motorverhaltens definieren, der mit dem Antriebssignal verbunden ist;
   Vergleichen (1602) der modellierten Reaktion mit einer tatsächlichen Reaktion des Motors auf das Antriebssignal; und
   Identifizieren (1603) eines Motorfehlers, wenn die tatsächliche Reaktion des Motors außerhalb des Bereichs des erwarteten Motorverhaltens liegt, das durch die modellierte Reaktion definiert ist,
   wobei die Verfahren beim Identifizieren eines Motorfehlers sdas Ausführen eines Korrekturverfahrens (1280) umfasst, der Korrekturvorgang umfassend:

      Anpassen des Antriebssignals;
      Modellieren einer Reaktion des Motors auf das angepasste Antriebssignal;
      Vergleichen der modellierten Reaktion mit der tatsächlichen Reaktion des Motors auf das angepasste Antriebssignal; und
      Bestimmen, dass der Motorfehler korrigiert wurde, wenn die tatsächliche Reaktion des Motors innerhalb des Bereichs des erwarteten Motorverhaltens liegt, das durch die modellierte Reaktion definiert ist, andernfalls das Wiederholen des Korrekturvorgangs.

15. Computerprogramm, umfassend einen Computercode, der die Einrichtung nach Anspruch 1 veranlasst, das Verfahren nach Anspruch 14 durchzuführen.

## Revendications

1. Appareil (100) comprenant :

   au moins un processeur (102) ; et
   au moins une mémoire (104) comportant un code de programme informatique,
   l'au moins une mémoire (104) et le code de programme informatique étant configurés pour, avec l'au moins un processeur, amener l'appareil à :

      modéliser une réponse d'un moteur (220) à un signal de commande (443) à l'aide d'un ou de plusieurs filtres (212a, 212b, 330, 552, 630, 730), les un ou plusieurs filtres étant configurés pour définir une plage de comportements attendus du moteur (441, 442) associés au signal de commande ;
      comparer la réponse modélisée avec une réponse réelle du moteur au signal de commande ; et
      identifier une erreur de moteur si la réponse réelle du moteur est en dehors de la plage de comportements attendus du moteur (444) définie par la réponse modélisée, dans lequel, lors de l'identification d'une erreur de moteur, l'appareil est configuré pour exécuter une procédure de correction (1280), la procédure de correction comprenant :

         le réglage du signal de commande ;
         la modélisation de la réponse du moteur au signal de commande ajusté ;
         la comparaison de la réponse modélisée avec une réponse réelle du moteur au signal de commande ajusté ; et
         la détermination que l'erreur de moteur a été corrigée si la réponse réelle du moteur se situe dans la plage de comportements attendus du moteur définie par la réponse modélisée, sinon la répétition de la procédure de correction, et
         dans lequel l'appareil est l'un ou plusieurs d'un appareil de cuisine, d'un mixeur, d'un mixeur portable, d'un batteur, d'un mixeur-broyeur et d'un module pour un ou plusieurs de ces appareils.

2. Appareil (100) selon la revendication 1, dans lequel les un ou plusieurs filtres comprennent au moins un filtre récursif à temps discret configuré pour recevoir une séquence d'entrées de filtre indicatives de signaux de commande faisant partie d'une opération de commande, et générer une pluralité de sorties de filtre respectives définissant la réponse modélisée associée du moteur, et dans lequel l'appareil est configuré pour réviser itérativement la réponse modélisée avec chaque entrée de filtre de la séquence, à l'aide de la sortie de filtre de l'itération précédente comme rétroaction.

3. Appareil (100) selon la revendication 2, dans lequel l'au moins un filtre récursif à temps discret comprend une pluralité de filtres linéaires ayant chacun une constante de temps respective à utiliser pour réviser la réponse modélisée, les constantes de temps respectives définissant le temps nécessaire au moteur pour atteindre un pourcentage prédéfini de la vitesse terminale dans différentes conditions de charge pour le comportement attendu du moteur.

4. Appareil (100) selon la revendication 2, dans lequel l'au moins un filtre récursif à temps discret comprend un filtre non linéaire ayant des constantes de temps plus longues et plus courtes à utiliser pour réviser la réponse modélisée, les constantes de temps plus longues et plus courtes définissant le temps nécessaire au moteur pour atteindre un pourcentage prédéfini de la vitesse terminale dans une plage de conditions de charge correspondant au comportement attendu du moteur, et dans lequel l'appareil est configuré pour :

   comparer chaque entrée de filtre de la séquence avec la sortie de filtre de l'itération précédente ; et
   lorsque l'entrée de filtre et la sortie de filtre sont de même signe, passer de la constante de temps plus longue à la constante de temps plus courte lorsque l'amplitude de l'entrée de filtre est inférieure à l'amplitude de la sortie de filtre de l'itération précédente ; sinon, utiliser la constante de temps plus longue, et lorsque l'entrée de filtre et la sortie de filtre sont de signes opposés, utiliser uniquement la constante de temps plus courte.

5. Appareil (100) selon la revendication 2, dans lequel l'au moins un filtre récursif à temps discret comprend un filtre non linéaire (330) ayant des constantes de temps de montée et de descente à utiliser pour réviser la réponse modélisée, les constantes de temps de montée et de descente définissant le temps nécessaire au moteur pour accélérer et décélérer jusqu'à des pourcentages prédéfinis respectifs de la vitesse terminale, dans une condition de charge prédéfinie pour le comportement attendu du moteur, et dans lequel l'appareil est configuré pour :

   comparer chaque entrée de filtre de la séquence avec la sortie de filtre de l'itération précédente ; et

lorsque l'entrée de filtre et la sortie de filtre sont de même signe, passer de la constante de temps de montée à la constante de temps de descente lorsque l'amplitude de l'entrée de filtre est inférieure à l'amplitude de la sortie de filtre de l'itération précédente ; sinon, utiliser la constante de temps de montée, et lorsque l'entrée de filtre et la sortie de filtre sont de signes opposés, utiliser uniquement la constante de temps de descente.

6. Appareil (100) selon la revendication 5, dans lequel l'au moins un filtre récursif à temps discret comprend une pluralité de filtres non linéaires, chaque filtre non linéaire ayant des constantes de temps de montée et de descente associées à utiliser pour réviser la réponse modélisée, les constantes de temps de montée et de descente associées définissant le temps nécessaire au moteur pour accélérer et décélérer jusqu'à des pourcentages prédéfinis respectifs de la vitesse terminale, dans une condition de charge prédéfinie pour le comportement attendu du moteur, et dans lequel l'appareil est configuré pour :

mettre à l'échelle chaque sortie de filtre par un facteur d'échelle ;
déterminer, à partir des sorties de filtre mises à l'échelle de la pluralité de filtres non linéaires à chaque itération de la séquence, la valeur de sortie de filtre maximale mise à l'échelle et la valeur de sortie de filtre minimale mise à l'échelle ; et
si le signal de commande est positif :

comparer la réponse réelle du moteur à la valeur de sortie de filtre minimale mise à l'échelle, et
identifier une erreur de moteur si la réponse réelle du moteur est inférieure à la valeur de sortie de filtre minimale mise à l'échelle ; ou
si le signal de commande est négatif :

comparer la réponse réelle du moteur à la valeur de sortie de filtre maximale mise à l'échelle, et
identifier une erreur de moteur si la réponse réelle du moteur est supérieure à la valeur de sortie de filtre maximale mise à l'échelle.

7. Appareil (100) selon la revendication 6, dans lequel la pluralité de filtres non linéaires comprend un premier ensemble et un second ensemble, le rapport de chaque constante de temps de montée à sa constante de temps de descente correspondante dans le premier ensemble est égal à un premier facteur d'asymétrie, et le rapport de chaque constante de temps de montée à sa constante de temps de descente correspondante dans le second ensemble est égal à un second facteur d'asymétrie qui est inférieur au premier facteur d'asymétrie, éventuellement, dans lequel le premier ensemble et le second ensemble comprennent chacun de 4 à 8 filtres non linéaires ; ou
le rapport de chaque constante de temps de montée à sa constante de temps de descente correspondante est égal à un facteur d'asymétrie.

8. Appareil (100) selon la revendication 2, dans lequel l'au moins un filtre récursif à temps discret comprend un filtre non linéaire comprenant des premier et second filtres linéaires, chacun des premier et second filtres linéaires ayant une constante de temps respective à utiliser pour réviser la réponse modélisée, les constantes de temps définissant le temps nécessaire au moteur pour atteindre un pourcentage prédéfini de la vitesse terminale, du plus long au plus court, pour toutes les conditions de charge moteur prévues, et dans lequel l'appareil est configuré pour :

comparer chaque entrée de filtre de la séquence avec la sortie de filtre de l'itération précédente ; et
utiliser le second filtre linéaire lorsque l'entrée de filtre est inférieure à la sortie de filtre de l'itération précédente, sinon utiliser le premier filtre linéaire.

9. Appareil (100) selon la revendication 2, dans lequel l'au moins un filtre récursif à temps discret (730) comprend un filtre non linéaire comprenant des premier et second filtres linéaires (730a, 730b), chacun des premier et second filtres linéaires ayant une constante de temps respective à utiliser pour réviser la réponse modélisée, les constantes de temps définissant le temps nécessaire au moteur pour atteindre un pourcentage prédéfini de la vitesse terminale, du plus long au plus court, pour toutes les conditions de charge moteur prévues, et dans lequel l'appareil est configuré pour :

comparer (739) la sortie de filtre actuelle du premier filtre linéaire avec la sortie de filtre actuelle du second filtre linéaire ; et
réviser la réponse modélisée à l'aide de la sortie de filtre plus faible comme rétroaction à la fois pour les premier et second filtres linéaires, éventuellement, dans lequel l'au moins un filtre récursif à temps discret comprend un filtre non linéaire supplémentaire comprenant des premier et second filtres linéaires supplémentaires, chacun des premier et second filtres linéaires ayant une constante de temps respective à utiliser pour réviser la réponse modélisée, les constantes de temps définissant le temps nécessaire au moteur pour atteindre un pourcentage prédéfini de la vitesse terminale, du plus long au plus court, pour toutes les conditions de charge moteur prévues, et dans lequel l'appareil est configuré pour :

comparer la sortie de filtre actuelle du premier filtre linéaire supplémentaire avec la sortie de filtre actuelle du second filtre linéaire supplémentaire ; et
réviser la réponse modélisée à l'aide de la sortie de filtre plus élevée comme rétroaction à la fois pour les premier et second filtres linéaires supplémentaires.

10. Appareil (100) selon l'une quelconque des revendications 2 à 5 et 8 à 9, dans lequel l'appareil est configuré pour mettre à l'échelle la sortie de filtre de l'au moins un filtre récursif à temps discret par un facteur d'échelle (554) avant de comparer la réponse modélisée avec une réponse réelle du moteur au signal de commande, le facteur d'échelle représentant une charge en régime permanent du moteur.

11. Appareil (100) selon une quelconque revendication précédente, dans lequel l'appareil est configuré pour :

comparer le signal de commande à un premier seuil (446, 447) définissant un signal de commande de moteur minimal ; et
comparer la réponse modélisée du moteur avec la réponse réelle du moteur pour identifier une erreur de moteur uniquement si le signal de commande dépasse l'amplitude du premier seuil, et/ou
dans lequel l'appareil est configuré pour :

déterminer, sur la base du signal de commande, un second seuil (445) définissant une réponse de moteur modélisée minimale au signal de commande ;
comparer la réponse modélisée du moteur avec le second seuil ; et
si le signal de commande est positif :

comparer la réponse modélisée du moteur avec la réponse réelle du moteur pour identifier une erreur de moteur si la réponse modélisée est supérieure au second seuil ; ou
si le signal de commande est négatif :
comparer la réponse modélisée du moteur avec la réponse réelle du moteur pour identifier une erreur de moteur si la réponse modélisée est inférieure au second seuil.

12. Appareil (100) selon la revendication 1, dans lequel l'appareil est configuré pour fournir une indication de délai d'expiration de l'erreur de moteur si la réponse réelle du moteur est en dehors de la plage de comportements attendus du moteur après un temps prédéfini ou un nombre prédéfini de réglages du signal de commande.

13. Appareil (100) selon la revendication 12, dans lequel l'appareil est configuré pour ajuster l'un ou plusieurs parmi l'amplitude, le taux de changement et la polarité du signal de commande à chaque itération du réglage du signal de commande.

14. Procédé (1600) réalisé par l'appareil (100) selon la revendication 1, le procédé comprenant :

la modélisation (1601) d'une réponse d'un moteur (220) à un signal de commande à l'aide d'un ou de plusieurs filtres, les un ou plusieurs filtres étant configurés pour définir une plage de comportements attendus du moteur associés au signal de commande ;
la comparaison (1602) de la réponse modélisée avec une réponse réelle du moteur au signal de commande ; et
l'identification (1603) d'une erreur de moteur si la réponse réelle du moteur est en dehors de la plage de comportements attendus du moteur définie par la réponse modélisée,
dans lequel, lors de l'identification d'une erreur de moteur, le procédé comprend l'exécution d'une procédure de correction (1280), la procédure de correction comprenant :

le réglage du signal de commande ;
la modélisation d'une réponse du moteur au signal de commande ajusté ;
la comparaison de la réponse modélisée avec une réponse réelle du moteur au signal de commande ajusté ; et
la détermination que l'erreur de moteur a été corrigée si la réponse réelle du moteur se situe dans la plage de comportements attendus du moteur définie par la réponse modélisée, sinon la répétition de la procédure de correction.

15. Programme informatique comprenant un code informatique pour amener l'appareil selon la revendication 1 à réaliser le procédé selon la revendication 14.

Figure 1

Figure 2

EP 4 555 621 B1

x[n]

y[n]

330

331

332

333

334

335

336

337

338

G

T

X

X

a[n]

b[n]

Figure 3

Figure 4

31

Figure 5

Figure 6

EP 4 555 621 B1

Figure 7a

Figure 7b

Figure 7c

740

$$Y_{1uk}[n] = Y_{1u}[n] \times K\_Low \text{ if } Y_{1u}[n] > 0$$

$$Y_{1uk}[n] = Y_{1u}[n] \times K\_High \text{ Otherwise}$$

$Y_{1u}[n]$

$Y_{1uk}[n]$

$$Y_{2uk}[n] = Y_{2u}[n] \times K\_Low \text{ if } Y_{2u}[n] < 0$$

$$Y_{2uk}[n] = Y_{2u}[n] \times K\_High \text{ Otherwise}$$

$Y_{2u}[n]$

$Y_{2uk}[n]$

Figure 7d

Figure 7e

Figure 7f

EP 4 555 621 B1

Figure 8

Figure 9a

EP 4 555 621 B1

Figure 9b

Figure 9c

Figure 9d

1060

1061 → **Start**

1062 → Motor On? — No →

Yes

1063 → Read Motor Current and Voltage

1064 → Calculate Motor Back-EMF ($EMF_m$)

1065 → Execute Filter Difference Equation

1066 → Scale Filter Result ($EMF_f$)

1069

1067 → $EMF_m < EMF_f$ — No → Clear Jam Condition Flag

Yes

1068 → Set Jam Condition Flag

# Figure 10

1160

1161

Start

1162

Motor On? —No→

1170

Yes

Clear Jam Condition Flag

1176

Wait 'T' Seconds

1171

No← Motor On?

1163

Yes

Read Motor Current and Voltage

1164

Calculate Signed Motor Back-EMF ($EMF_m$)

1165

Pass Voltage information to the filter set and Execute All Filter Difference Equations

1172

Determine the Filter Set Outputs Maxima ($y[n]max$) and Minima ($y[n]min$)

A

B

## Figure 11a

1160

(A)   (B)

1173

x[n] > DMin
AND
y[n]min >
Y_Min[n]

Yes

No

1175

x[n] < -DMin
AND
y[n]max > -
Y_Min[n]

No

Yes

1176

$EMF_m >$
y[n]max

Yes

1168

Set Jam Condition Flag

No

1169

Clear Jam Condition Flag

1174

$EMF_m <$
y[n]min

Yes

1168

Set Jam Condition Flag

No

1169

Clear Jam Condition Flag

Figure 11b

1280

1281

Start

1282

Manoeuvre
Flag Set? — Yes

No

1283

Jam
Condition
Flag Set? — No

Yes

1284

Manoeuvre
Time >
$T_{MAX}$? — Yes

1285

Set Correction Count
'N' to '1'

No

1286

Increment Correction
Count 'N'

1287

$N > N_{MAX}$? — Yes

1288

Shut Down Motor
Program Cycle

No

1289

Execute Jam Correction
Manoeuvre Process for
the value 'N'

Figure 12

1380

1381

1390

1383

1385

1386

1387

1391

1389

1392

1388

Start

Motor On? — No →

Yes

Jam Condition Flag Set? — No →

Yes

Set Correction Count 'N' to '0'

Increment Correction Count 'N'

N > N$_{MAX}$? — Yes → Shut Down Motor Program Cycle →

No

Suspend User Program Control

Execute Jam Correction Manoeuvre Process for the value 'N'

Jam Condition Flag Set? — Yes

No

Reinstate User Program Control

Figure 13

1400

1401

**Start**

1402

Set Manoeuvre Flag
Set P to '0'

1403

Suspend User Program
Control and Save Motor
Drive Setting 'VP'

1404

Ramp Motor Voltage to
'V(N,P)' at Rate 'R(N,P)'

1405

Target
Voltage
Reached

No

Yes

1406

Increment 'P'

1407

$P > P_{MAX}$?

No

Yes

A

Figure 14a

1400

A

1408 → Ramp Motor Voltage to
'VP' at Rate 'R'

1409 → Target
Voltage
Reached — No

Yes

1410 → Reinstate User Program
Control

1411 → Clear Manoeuvre Flag
Set Manoeuvre Time to
'0'

1412 → Finish

Figure 14b

1500

1501 → Start

1502

Set P to '0'

1504

Ramp Motor Voltage to 'V(N,P)' at Rate 'R(N,P)'

1505

Target Voltage Reached — No

Yes

1506

Increment 'P'

1507

P > P$_{MAX}$? — No

Yes

1512 → Finish

Figure 15

1600

1601

Modelling a response of a motor to a drive signal using one or more filters, the one or more filters configured to define a range of expected motor behaviour associated with the drive signal.

1602

Comparing the modelled response with an actual response of the motor to the drive signal.

1603

Identifying a motor error if the actual response of the motor is outside the range of expected motor behaviour defined by the modelled response.

Figure 16

**EP 4 555 621 B1**

**Patent documents cited in the description**

- US 2018367073 A1
- US 2018130494 A1
- US 2008309366 A1